(19) Europäisches Patentamt
European Patent Office
Office européen des brevets

(11) **EP 1 929 322 B1**

(12) **EUROPEAN PATENT SPECIFICATION**

(45) Date of publication and mention
of the grant of the patent:
**17.07.2013 Bulletin 2013/29**

(21) Application number: **06779200.2**

(22) Date of filing: **24.08.2006**

(51) Int Cl.:
*G01R 33/465* (2006.01)

(86) International application number:
**PCT/GB2006/003169**

(87) International publication number:
**WO 2007/023289 (01.03.2007 Gazette 2007/09)**

(54) **BIOMOLECULAR STRUCTURE DETERMINATION INVOLVING SWARM INTELLIGENCE**

BIOMOLEKULARE STRUKTURBESTIMMUNG UNTER ANWENDUNG VON SWARM-INTELLIGENZ

DETERMINATION DE STRUCTURES BIOMOLECULAIRES A L'AIDE D'UNE INTELLIGENCE EN ESSAIM

(84) Designated Contracting States:
**AT BE BG CH CY CZ DE DK EE ES FI FR GB GR HU IE IS IT LI LT LU LV MC NL PL PT RO SE SI SK TR**

(30) Priority: **24.08.2005 GB 0517349**

(43) Date of publication of application:
**11.06.2008 Bulletin 2008/24**

(73) Proprietor: **ISIS INNOVATION LIMITED**
**Summertown,**
**Oxford OX2 7SG (GB)**

(72) Inventors:
• **PICKFORD, Andrew, R.**
**Oxford OX2 8BX (GB)**
• **ALMOND, Andrew**
**Silkstone S75 4ND (GB)**

(74) Representative: **Maggs, Michael Norman et al**
**Kilburn & Strode LLP**
**20 Red Lion Street**
**London WC1R 4PJ (GB)**

(56) References cited:
• **MEILER J, WILL M: "Automated structure elucidation of organic molecules from 13C NMR spectra using genetic algorithm and neural networks" J CHEM INF COMPUT SCI, vol. 41, 2001, pages 1535-1546, XP002408966**
• **ADLER M: "Modified genetic algorithm resolves ambiguous NOE restraints and reduces unsightly NOE violations" PROTEINS: STRUCTURE, FUNCTION, AND GENETICS, vol. 39, 2000, pages 385-392, XP002408967**
• **ONO I ET AL: "Global optimization of protein 3-dimensional structures in NMR by a genetic algorithm" PROCEEDINGS OF THE 2002 CONGRESS ON EVOLUTIONARY COMPUTATION. CEC'02 (CAT. NO.02TH8600), 12 May 2002 (2002-05-12), pages 303-308, XP002408968**
• **BAYLEY MJ ET AL: "GENFOLD: A genetic algorithm for folding protein structures using NMR restraints" PROTEIN SCIENCE, vol. 7, 1998, pages 491-499, XP002408969**
• **FALK M ET AL: "Determination of the stereochemistry of natural products from nuclear magnetic resonance data by constrained molecular dynamics" JOURNAL OF COMPUTATIONAL CHEMISTRY, vol. 17, no. 4, 1996, pages 409-417, XP002408970**
• **RESSOM H ET AL: "Particle swarm optimzation for analysis of mass spectral serum profiles" GECCO 2005 - GENETIC AND EVOLUTIONARY COMPUTATION CONFERENCE; WASHINGTON, D.C., UNITED STATES, 25 June 2005 (2005-06-25), pages 431-438, XP001248186**

EP 1 929 322 B1

## Description

The present invention is concerned with biomolecular structure determination and in particular with a method for determining biomolecular structures from ambiguous experimental data using the principles of swarm intelligence.

BACKGROUND OF THE INVENTION

A fundamental paradigm in the biological sciences is that the three-dimensional structure of proteins and nucleic acids, essentially the building blocks of life, determine their function. This paradigm emerged from the pioneering studies of Watson and Crick, who determined the structure of DNA, and Perutz and Kendrew, who solved the first structure of a protein. It soon became clear that biological macromolecules are highly structured, and that all proteins share certain three-dimensional structural features: coils ($\alpha$-helices) and sheets ($\beta$-sheets), and that DNA forms an anti-parallel double helix zipped together with hydrogen bonds. These structural elements are central to their biological activity. A further breakthrough came when the first structure of a protein enzyme was resolved. The enzyme was found to have a binding pocket where the target ligand molecule fits exactly before undergoing some biochemical process, making enzymes highly specific. Today the pharmaceutical industry is interested in understanding how molecules interact with each other because it allows them to develop new drugs. Often drugs are artificial ligands that have the correct shape to fit in a binding pocket of a protein receptor, which is part of some biochemical pathway that they have established. A three-dimensional structural analysis of the receptor, while not sufficient to rationally design a ligand, can be used to propose a set of moiecules that are likely to be a ligand and which may potentially be a new drug.

In a molecular experiment, each observation arises from one or more characteristics of a component of the molecule. Given sufficient experimental observations, the molecular structure may be modelled with reliability. However, when multiple components of the molecule share the same characteristic(s) the experimental observation is ambiguous, in that it can be assigned to more than one component of the molecule. Thus, the information content of the experimental observation is reduced leading to a less reliable model of the molecular structure.

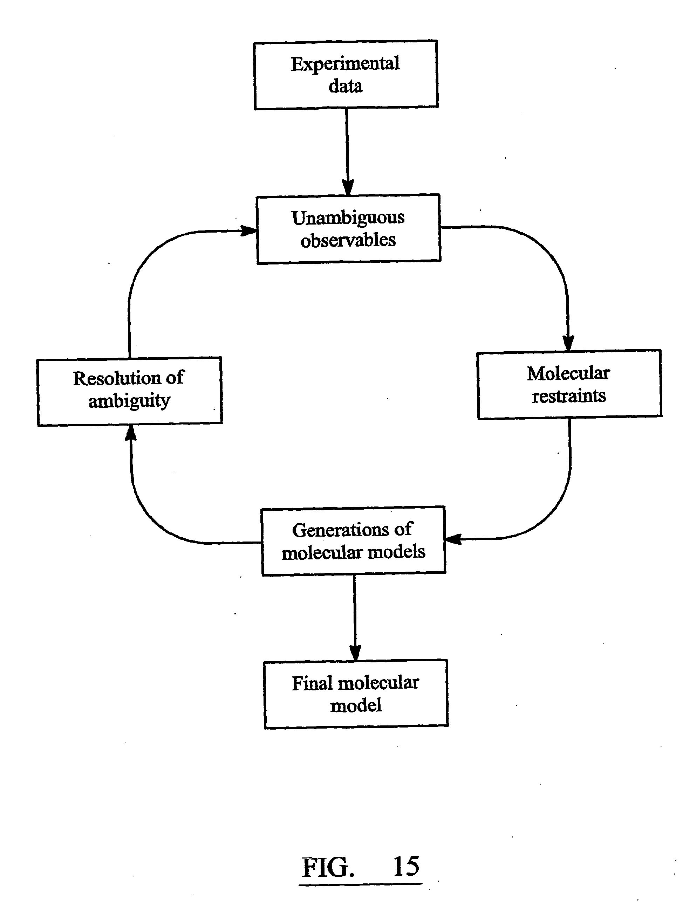

The current best-practice in molecular modelling from experimental data that includes ambiguous observables is to adopt an iterative, or cyclic, scheme that aims to gradually resolve the experimental ambiguities with each cycle (Figure 15). Initial models are generated that satisfy the unambiguous experimental observables. These preliminary models are used to evaluate the possible assignments of the remaining observables with the aim of resolving their ambiguity. The newly-resolved assignments are combined with the previously unambiguous observables in the subsequent cycle of molecular model generation and reassignment. The iterative scheme continues until all ambiguous experimental observables have been resolved and the final molecular model is produced. An iterative assignment scheme for resolving ambiguity in experimental observations is shown in Figure 15.

Colonies of social insects can perform complex tasks (e.g. foraging, cooperative hunting and nest building) despite the simplicity of the individuals. While walking to/from a food source ants deposit pheromones on the ground which attracts other ants through a process known as "stigmergy". In time, a pheromone trail will mark the optimal route from nest to food. Such "swarm intelligence" has been used in mathematical algorithms that can potentially solve complex combinatorial optimization problems.

Nuclei with an odd mass or odd atomic number have *nuclear spin* (in a similar fashion to the spin of electrons); this includes $^1H$ and $^{13}C$ (but not $^{12}C$) and $^{15}N$. The spins of nuclei are sufficiently different that techniques, for example NMR experiments can be sensitive for only one particular isotope of one particular element by selective excitation on a multichannel NMR spectrometer. The NMR behaviour of $^1H$, $^{13}C$ and $^{15}N$ nuclei are typically exploited by Biochemists, being the typical constituents of proteins, which by application of suitable *pulse sequences* can be used to deduce their structure.

At natural abundance proteins contain large proportions of the $^1H$ NMR active nuclei, but small proportions of the other nuclei of interest, $^{13}C$ and $^{15}N$, see Table 1 below.

| Nucleus | Natural abundance (%) |
|---|---|
| $^1H$ | 99.985 |
| $^2H$ | 0.015 |
| $^{12}C$ | 98.89 |
| $^{13}C$ | 1.11 |
| $^{14}N$ | 99.63 |
| $^{15}N$ | 0.37 |

Molecular biology protocols allow proteins to be produced with enhanced abundances of $^{13}C$ and $^{15}N$. This permits heteronuclear NMR experiments to be performed, where protons can be correlated with other heteronuclei and use their *chemical shift dispersion* to remove overlap by application of 2D and 3D NMR experiments. From these experiments the chemical shifts of individual nuclei, even in large proteins, can be *assigned*.

The precise resonant frequency of the energy transition is dependent on the effective magnetic field at the nucleus. This field is affected by electron shielding which is in turn dependent on the chemical environment. As a result, information about the chemical environment of a nucleus can be derived from it resonant frequency. In general, the more the nucleus is electronegative, the higher the resonant frequency. Other factors such as ring currents (anisotropy) and bond strain affect the frequency shift, The chemical shift is defined with respect to the resonant frequency of a reference compound, for example tetramethylsilane (TMS). In this case the chemical shift of TMS would be defined to be zero. This scale is useful practically because it is independent of magnetic field strength.

$$\delta_{ppm} = 10^6 \times (\nu - \nu_{ref})/\nu_{ref} \qquad \text{Eq. 1.1}$$

The NMR technique is particularly useful because it permits the through-space distances between nuclei to be measured. This is possible because of dipolar spin-spin coupling between nuclei. The dipolar coupling is dependent on the distance between the nuclei $(1/r^6)$ and their relative orientation to the magnetic field $(1-\cos^2\theta)$. In solution phase NMK (as applied here) the angular component averages to zero and hence dipolar couplings are not observed directly in NMR spectra. They do, however, affect the relaxation rates of nuclei. Distance information is therefore extracted from relaxation experiments, which take advantage of phenomena such as the nuclear Overhauser enhancement.

If one nucleus is selectively irradiated then it can be shown that the NMR signals corresponding to nuclei that are located close in space are enhanced. This is called the nuclear Overhauser enhancement. The amount of enhancement is related to the distance between the nuclei and hence can be used as a method for measuring nuclei. However, this is a laborious process and is not used in protein NMR because individual nuclei cannot be excited separately. Instead, the NOESY (<u>NOE S</u>pectroscop<u>Y</u>) experiment is typically applied. In its most basic incarnation it is a 2D experiment that correlates all protons. During a user definable relaxation period (the *mixing time*) magnetisation is transferred between nuclei that are closely separated in space. Therefore, signal is seen to move from the diagonal to cross-peaks that are found at the chemical shifts of the two nuclei involved. Due to the nuclear Overhauser effect the *cross-relaxation* rate for this transfer is related to the distance $(1/r^6)$. The intensity of cross peaks are related to the distance between nuclei. Low signal equates to large distance, large signals to close distances. If the two nuclei have been identified in the protein structure and *assigned* to particular chemical shifts then this distance can be used as a *conformational restraint* in the NMR structure determination problem. The cross-peaks are commonly referred to as "NOEs". Typically, the assignment of proton chemical shifts uses heteronuclei ($^{15}N$ and $^{13}C$) and NOESY spectra are obtained from 2D proton spectra, or a 3D experiment with an extra $^{15}N$ dimension.

When spin *pairs* are isolated (and the protein of interest is tumbling isotropically) the cross-relaxation rate can be shown to be exactly proportional to $1/r^6$. Here, the intensities for a particular mixing time are easy to calculate. However, this is not true in a protein, where the density of protons can be high. In general this problem has to be solved by taking into account all possible proton pathways - the so called *full relaxation matrix* approach. Each possible interaction is represented by a cross-relaxation rate in a 2D matrix, and the intensities are computed using linear algebra approaches. This is computationally intensive and complicated. However, even in a protein, if the mixing time is kept short, then the NOESY cross-peak intensity is *approximately* proportional to 1/r6. This is the *independent spin-pair approximation*. The largest useful mixing time can be estimated by performing test experiments with varying mixing times, and establishing the point at which the NOESY cross-peak intensities become non-linear with mixing time. This regime is most frequently used in NMR structure determination of proteins because of its computational simplicity and linearity.

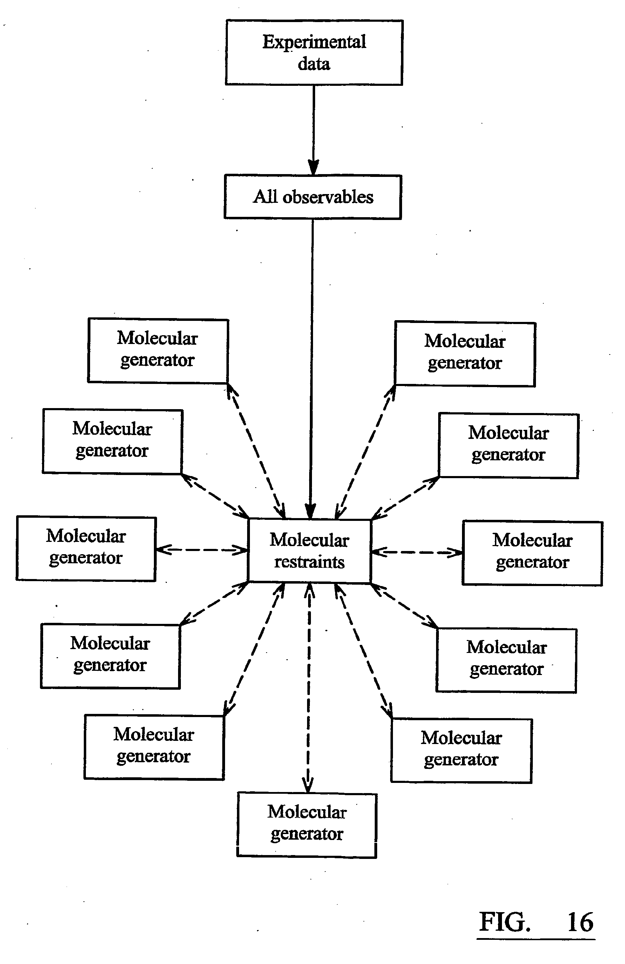

The donor and acceptor protons in an NOE are identified from the chemical shifts of the NOESY crosspeak. When each chemical shift relates to only a single proton resonance, the donor and acceptor protons can be assigned unambiguously. However, when either of the chemical shifts can be attributed to two or more proton resonances, the NOE is said to be ambiguous. In order to resolve this ambiguity, we need to know the three-dimensional structure, but in order to determine the three-dimensional structure we need to assign all the NOEs. This dilemma is known as the NOE assignment problem and is illustrated in Figure 16.

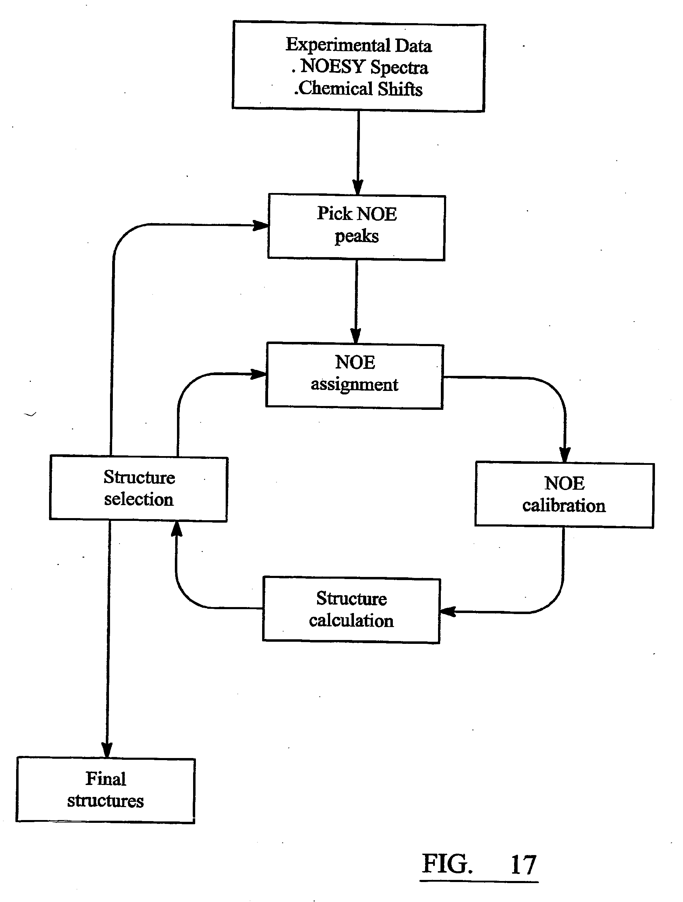

To date, the most successful strategies for resolving the NOE assignment problem have used iterative assignment schemes analogous to that in Figure 17. This is the strategy adopted by the most commonly used computer programs for biomolecular structure determination today, *ARIA/X-PLOR/CNS*, *DYANA/CYANA* and *AUTOSTRUCTURE*. In each case, those crosspeaks in the NOESY spectrum that are distinguishable from noise are "picked" in preparation for NOE assignment and interproton distance calibration. Thereafter, there follows multiple cycles of NOE assignment and calibration, biomolecular structure determination and structure selection. In the first round, the unambiguous NOEs are calibrated into distance restraints in order to calculate a preliminary set of structures, a fraction of which are selected for NOE reassignment. Because only a subset of the possible experimental observations is used, these initial conformers have a very low level of precision. However, they may be of sufficient accuracy to discriminate between the assignment possibilities of a subset of the ambiguous NOEs. Therefore, the list of assigned NOEs is expanded and the fraction of unused experimental observations decreases. Eventually, after multiple cycles of reassignment, re-calibration and re-calculation the procedure yields a solution structure that is compatible with the crosspeaks picked from the NOESY data.

The multi-step iterative assignment procedure has flaws at every stage. For instance, the peak-picking can be highly erroneous and subjective, particularly in the case of identifying the chemical shifts, and measuring the intensities/volumes of overlapping NOESY crosspeaks. Another disadvantage is that mistakes made in the assignment of the initial set of unambiguous NOEs are propagated through every subsequent cycle, leading to consequent mis-assignments and mis-calibrations and resulting in an erroneous solution structure.

An iterative assignment also performs a restraint calibration on a limited subset of NOEs rather than the whole spectrum leading to further subjectivity. Furthermore, the poor definition of the initial set of biomolecular structures requires that many conformers must be calculated for a statistically meaningful analysis of the ambiguous NOEs and the selection of structures is prone to subjectivity and bias. In addition, the iterative assignment is time consuming, and is highly wasteful in that the number of structure calculations performed far exceeds the number of conformers required to define the solution structure.

The closest prior art is considered to be Meiler J, Will M: "Automated structure elucidation of organic molecules from 13C NMR spectra using genetic algorithm and neural networks" J Chem Inf Comput Sci, vol. 41, 2001, pages 1535-1546. This discloses an automated method of determining the structure of an organic molecule, as discussed above. The described method attempts to determine an unknown covalent structure of a molecule making use of a genetic algorithm to create and test a finite number of probable molecular structures, each having only a small deviation from experimentally observed NMR data. The method includes creating in a computer a swarm of molecular structure generators, each having the same covalent structure as the biomolecule whose three-dimensional conformation is to be determined, but with differing initial conformations (i.e step (a) defined in claims 1 and 4, respectively). The molecular structure generators then explore possible conformations of the biomolecule subject to restraints which are derived from experimentally obtained NMR spectra.

## SUMMARY OF THE INVENTION

The present invention seeks to alleviate the problems associated with the prior art by utilizing the principle of swarm intelligence to achieve determination of bio-molecular structures from ambiguous experimental observables.

This is achieved through the creation of a swarm of *molecular structure generators*, which are able to communicate via a global set of molecular restraints derived from the experimental observables to determine the molecular structure in a cooperative manner.

According to a first aspect of the present invention, a computational method of determining a three-dimensional conformation of a biomolecule is defined by the features set out in claim 1.

According to a second aspect of the invention, an apparatus adapted to determine a three-dimensional conformation of a biomolecule is defined by the features set out in claim 4.

In utilizing the principles of swarm intelligence, the biomolecules are able to communicate via a common restraint list. Any single conformer which encounters a favourable sub-structure, for example, a native-like $\alpha$-helical turn or $\beta$-hairpin in proteins, may encourage the other members of the swarm to adopt this conformation by updating the molecular restraints. Therefore, the molecules cooperate in finding the optimal restraints and thus determine their own molecular structure.

The present invention offers particular advantageous over previously used techniques such as iterative assignment. Firstly, there need be no peak picking of the NOESY spectra which is highly speculative and, therefore, no problems associated with overlapped and/or aliased crosspeaks. Furthermore, there need be no calibration of interproton distance restraints. Instead, those distances that give rise to "good" spectral solutions are remembered. Interproton distance restraints are transient and modified on-the-fly during the course of the swarm evolution, so assignment errors are neither propagated nor amplified. The technique is also objective: all possible donor-acceptor NOE pars may be considered from the outset and there need be no selection of conformers.

In FIG 16, a swarm intelligence schema is illustrated for resolving ambiguity in experimental observations. The swarm of molecular structure generators are able to communicate via a global set of molecular restraints derived from the observables and determine the molecular structure in a cooperative manner.

The present invention will now be described in more detail with reference to the exemplary embodiments which are provided by way of example only.

## BRIEF DESCRIPTION OF THE DRAWINGS

FIG 1 is an illustration of an overview of the architecture of NMRswarm.
FIG 2 is a preparation of the Topology and Swarm.
FIG 3 is a preparation of the NMR. Data.
FIG 4 shows On-the-Fly NOESY Backcalculation in NMRswarm.
FIG 5 (cancelled)
FIG 6 is a graphical user interface of NMRSwarm.
FIG 7 is a geometry user interface of NMRSwarm.
FIG 8 shows the Library GUI of NMRSwarm.
FIG 9 shows how a segment is built in the Topology GUI of NMRSwarm
FIG 10 is a segment viewer in the Topology GUI of NMRSwarm.
FIC 11 displays the NOE Viewer/Editor in the Topology GUI of NMRSwarm.
FIG 12 displays a Swarm GUI of NMRSwarm.
FIG 13 shows the NMR conditions GUI of MRSwarm.

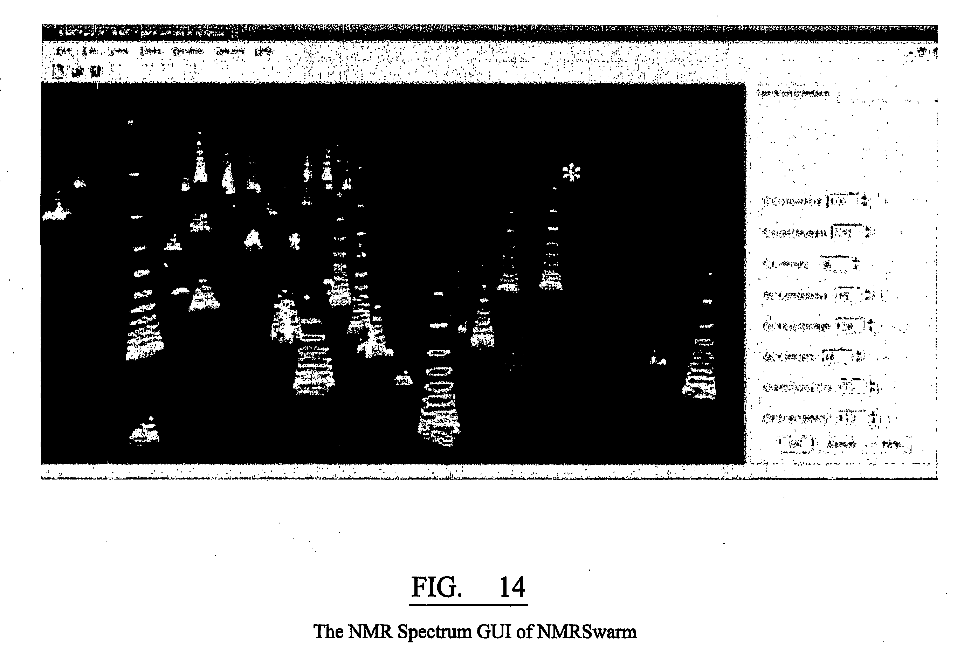

FIG 14 depicts the NMR Spectrum GUI of NMRSwarm.
FIG 15 is an iterative assignment scheme for resolving ambiguity in experimental observations.
FIG. 16 is a swarm intelligence scheme for resolving ambiguity in experimental observations.
FIG 17 is a graphic illustration of an iterative assignment scheme for resolution of ambiguous NOEs.

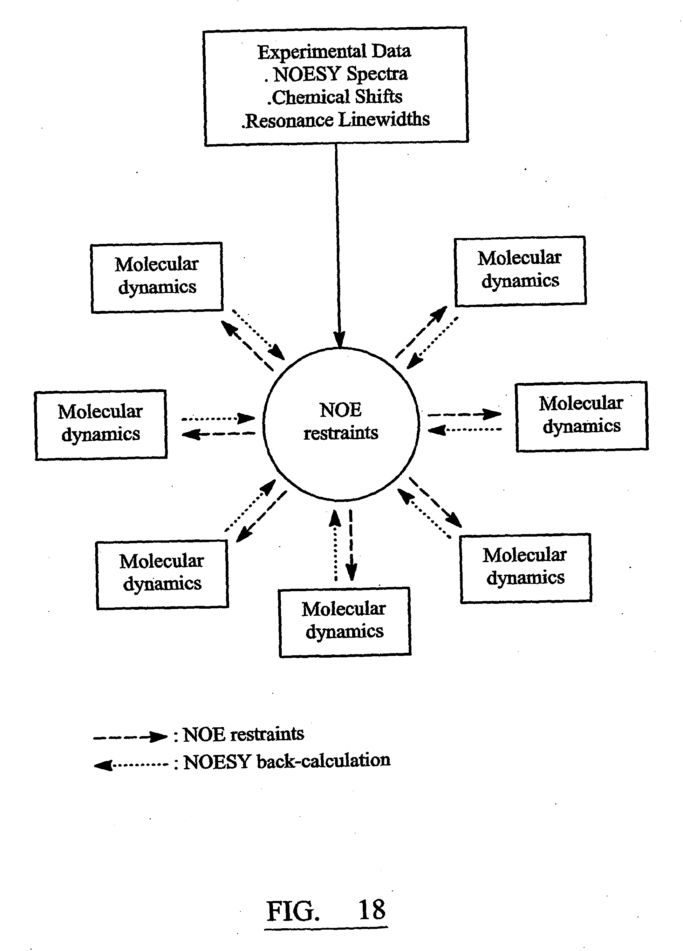

FIG 18 is a schematic representation of a swarm intelligence-based NMR structure determination
FIG 19 is a graphic representation of a pseudo-harmonic $E_{NOE}$ potential.
FIG 20 is a graphical representation of the half-sigmoidal temperature and Van der Waals force constant ramps applied during the simulated annealing.
FIG 21 illustrates the evolution of the $^1$F2 module swarm.
FIG 22 illustrates a correlation between back-calculated and experimental NOES data.
FIG 23 illustrates a comparaison of the Swarm Intelligence NMR structure of $^1$F2 with that derived previously by the iterative-assignment of NOES.
FIG 24 illustrates the evolution of the FERM3 swarm.
FIG 25 illustrates a comparison of the Swarm Intelligence NMR structure of FERM3 with the one derived from X-ray crystallography.

### An Overview of the NMRSwarm Program

### The Modules of NMRSwarm.

The architecture of NMRSwarm can be split into four approximatelyautonomous modules: Geometry, Library, Topology, Swarm and NMR. These provide the C++ classes for the program, the building blocks upon which the architecture is constructed. Two additional modules, Utility and Molecule perform supplementary roles. The Utility module provides numerous base classes that are inherited by many other classes in the other Modules. The Molecule module provides a family of classes that are the bases for the construction of the Library, Topology and Swarm objects.

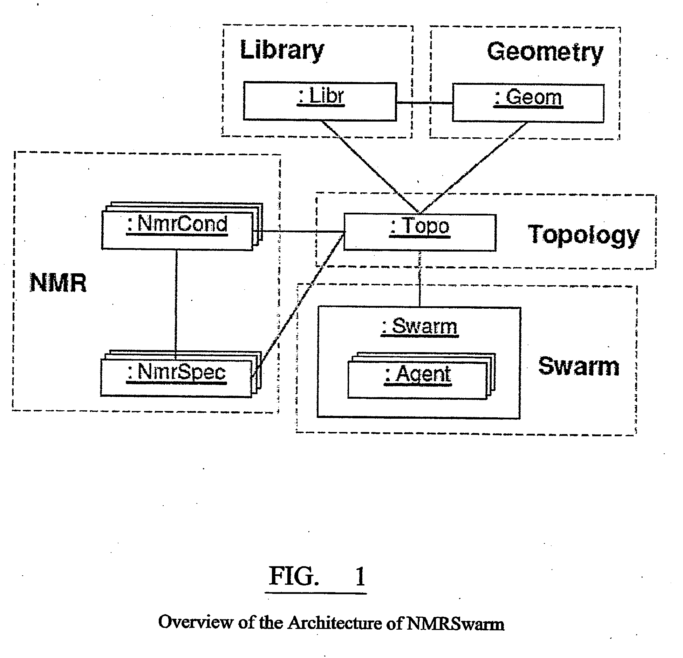

The key interactions between objects in the NMRSwarm program are depicted in Figure 1. The Swarm itself consists of an array of molecular Agents, each of which is cloned from a Topology template (:Topo) which is turn is constructed from a Library (:Libr) of residues and linkers and a database of geometric parameters (:Geom). The Topology also provides atomic information to the NMR module for the construction of resonances and spectral crosspeaks which are accesed by the Swarm during backcalculation of NMR spectra.

### Preparing the Topology and Swarm

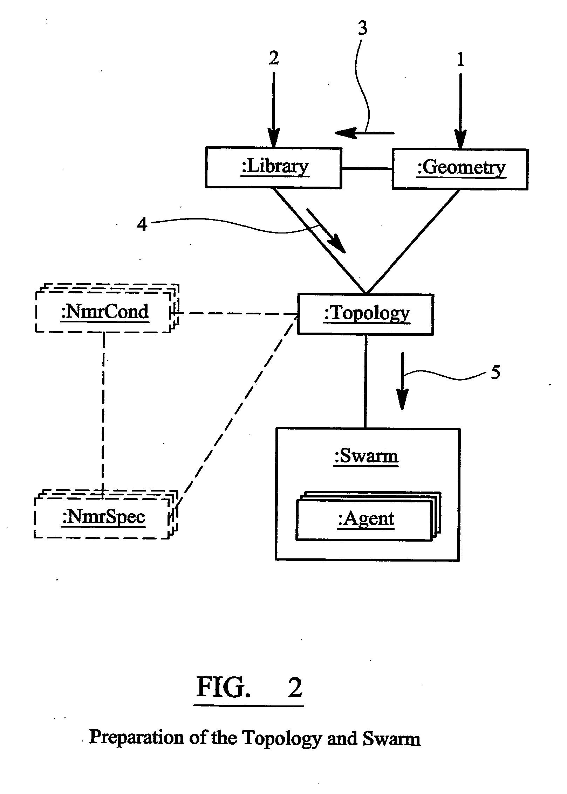

The first stage in the swarm intelligence structure calculation process in NMRSwarm is the preparation of one or more segments in the molecular topology (Figure 2). This is performed by "polymerization" of Library residues (: LibrResi) using Library links (:LibrLink) according to a user-defined sequence. The Library residues and patches must first be generated from templates input from file or the graphical user interface (GUI), and suitable Geometry data.

The completed Topology has all the information required to clone Agents and to produce NMR resonance lists for each set of the NMR conditions. It also contains a master NOE array for management of the NOE restraints during the swarm intelligence structure calculation process.

**Preparing the NMR Data**

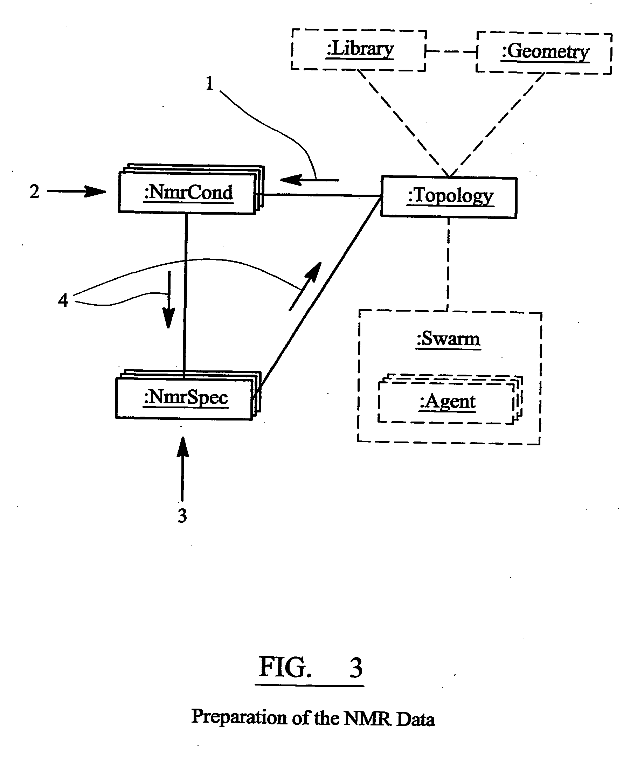

An NMR condtions object (:NmrCond) is constructed for each set of conditions (field strength, pH, ionic strength, etc.) under which NMR spectra were recorded on the specified Topology. Upon construction, the NmrCond object shown in Figure 3 automatically generates a complete (but unassigned) list of NMR resonances (:NmrReso) for the Topology which may be edited by the user via the GUI or modified by loading of previously stored resonance information from file.

Multiple NOESY NMR spectra (:NmrSpec) can then be loaded into each set of NMR conditions. Upon loading of the spectrum, NMRSwarm automatically generates all possible NOE crosspeaks (:NmrXpk) and links these to the NOE array in the Topology. Subsequent alterations to the NMR resonances result in spontaneous changes in the magnitude, shape and/or positions of the NOE crosspeaks in the spectra. Regions of the NMR spectra which contain artefacts may be omitted from analysis through the application of masks (:NmrMask).

**Swarm Intelligence Structure Calculation in NMRSwarm**

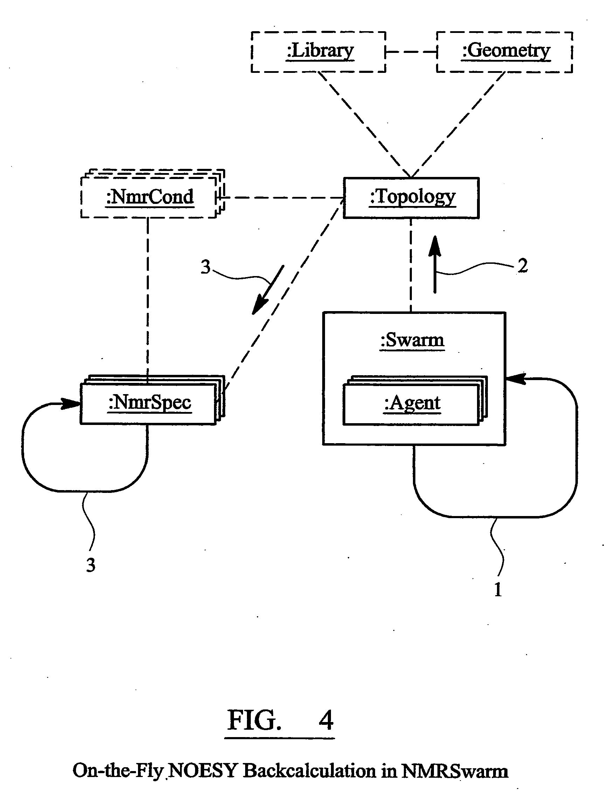

The swarm intelligence structure calculation method in NMRSwarm is summarized in Figure 4. In brief, the Swarm of molecular Agents are undergoing restrained molecular dynamics simulations starting from randomized conformations but all governed by a global NOE restraint list (in the: Topo). Periodically, the current inter-proton resonance distances at any point in time for one randomly-chosen Agent are copied into a "test slot" of the NOE array. From here they are used to back-calculate hypothetical NOES spectra that would be produced if the current conformation was the correct one.

These back-calculated NOES spectra are normalizad against the experimental NOES intensities by calculating the correlation coefficients over those ummasked, non-diagonal spectral intensities.

The goodness-of-fit between the back-calculated and experimental NOESY crosspeaks is evaluated from a $\chi^2$ test of the intensities. Those test interproton resonance distances that resulted in an improvement in the $\chi^2$ of the crosspeaks are recorded and used to update the NOE restraints in the global NOE list. The new NOE distance restraints are passed back to all Agents in the Swarm via the Topology, and the restrained molecular dynamics simulations continue. In this way, the NOE distances in those regions of the conformation of the tested Agent that agree well with the experiment data are communicated to all other Agents in the Swarm. The backcalculation-and-update cycle is then repeated for each of the other Agents.

Once all Agents have been tested, the memorized $\chi^2$ values for the NOESY crosspeaks are increased by a constant factor (typically 1-5%). This so called "pheromone decay" makes an NOE distance update more likely for the subsequent cycles, allowing for mistakes in the NOE assignment procedure to be corrected by the Swarm.

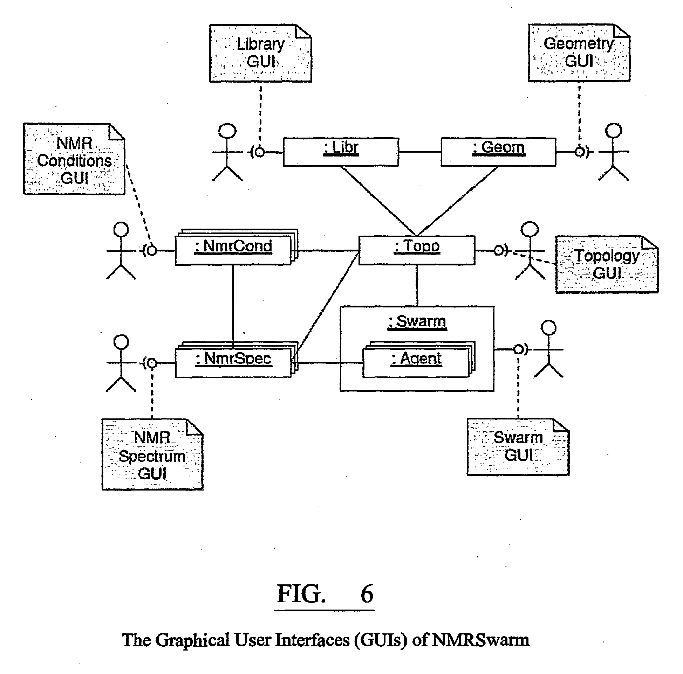

In FIG 6, a biomolecular swarm is defined as a colony of molecular agents that are searching their conformational (interproton distance) space through molecular generators, which, in this case, are parallel restrained molecular dynamics simulations. Each of these agents back-calculates simulated NOES data from its current conformation, and, depending on its degree of agreement with the experimental NOESY data, updates a global interproton distance list that is then applied as restraints in the molecular generators. Thus, the agents communicate by stigmergy, mutually updating and reacting to the restraint list.

In such a swarm, if any of the molecular agents encounters a conformation that agrees well with the experimental data (for example, a native-like β-hairpin or an α-helical turn in proteins), this knowledge is communicated instantly to the other molecule agents in the

swarm. Therefore, over time the NOE restraint list will evolve to the correct set of interproton distances that describes the conformation of the molecule. The swarm of molecular agents is then attracted by this set of restraints towards the correct three-dimensional structure.

**Graphical User Interface**

The graphical user interface (GUI) of NMRSwarm allows the user to observe and interact with all aspects of the swarm intelligence structure calculation process. Figure 6 shows the GUI comprising six separate interfaces allowing complete observation of, interaction with and intervention in the entire NMRSwarm system, i.e. the Geometry, Library, Topology, NMR Conditions, NMR Spectrum and Swarm modules.

**Geometry Interface**

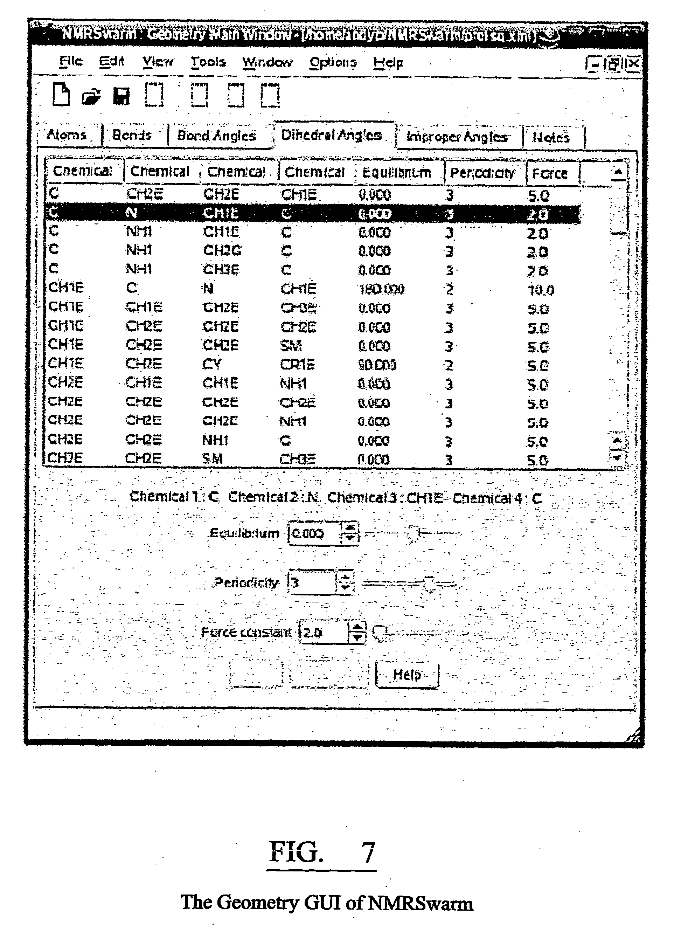

The Geometry multiple document interface of NMRSwarm allows the user to create, edit, load, save and delete Geometry files. Each document has multiple window tabs which provide access to the Geometry atoms, bonds, angles, dihedrals and impropers, which is shown in Figure 7. Clicking on any of the Geometry Atoms updates the Atom attributes editor sliders at the bottom of the table allowing the user to modify these values. Clicking on any of the Geometry constraints updates the equilibrium distance and force constant (and periodicity in the case of dihedrals) editor sliders at the bottom of the table and allows the user to manually edit these values for the selected constraint.

## Library Interface

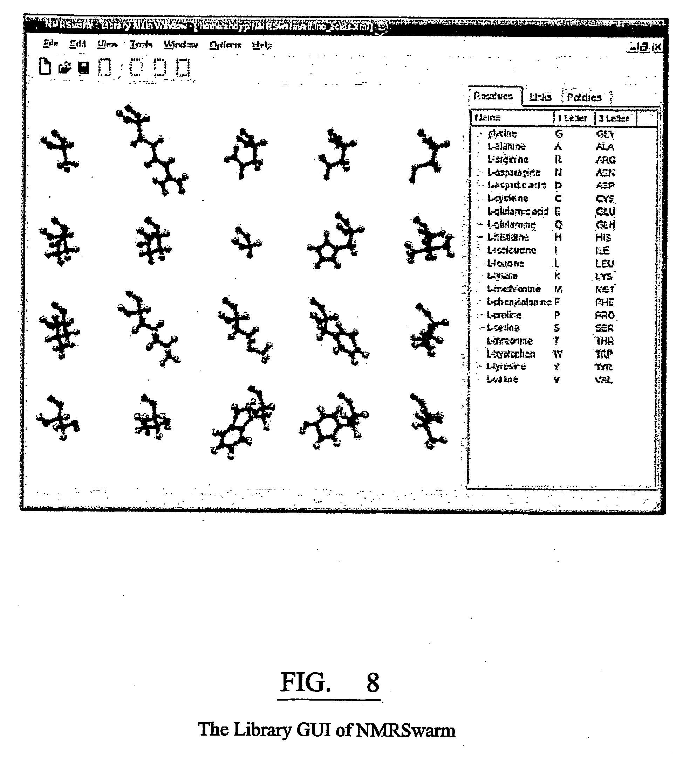

The Library multiple document interface of NMRSwarm shown in Figure 8 allows the user to load, save and delete Library files. Each document has an OpenGL-based molecular viewer, which presents the Library Residues in any of a number of viewing modes (lines, ball-and-stick, space-fill or tubes) and multiple window tabs, which provide access to information on the Library Residues, Patches and Links.

## Topology Interface

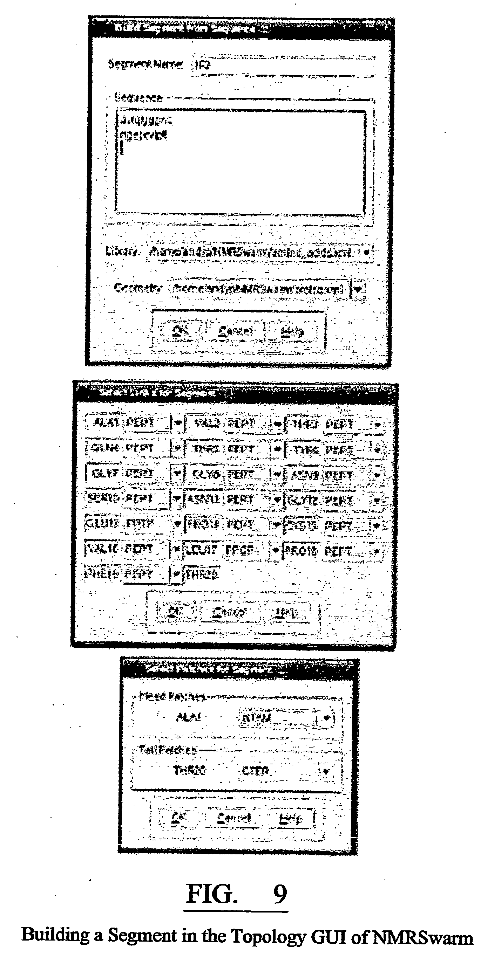

The Topology multiple document interface of NMRSwarm allows the user to create, edit, load, save and delete Topology files. The topologies are written to files in an XML (extensible markup language) format. Topology segments are built from sequences of library residues using a single-letter code and the appropriate Library and Geometry document files (Figure 9). Each segment is given a four-letter name similar to the accession code of a Protein Data Bank (PDB) entry.

Inter-residue Library links are selected for each pair of residues, for example a *trans*peptide bond (PEPT) or a cisproline peptide cond (PPCP) in a polypeptide chain. Finally, the first and last residues may be modified using a Library patch, e.g. with primary amine (NTAM) and carboxylate (CTER) groups for the N- and Ctermini of a polypeptide.

The resultant topology segment may be examined using the OpenGLbased molecular viewer of NMRSwarm which presents the topology in any of a number of viewing modes (lines, ball-and-stick, spacefill or tubes). The Topology GUI also presents a list view tree of the segment structure together with tabulated lists of its geometric constraints.

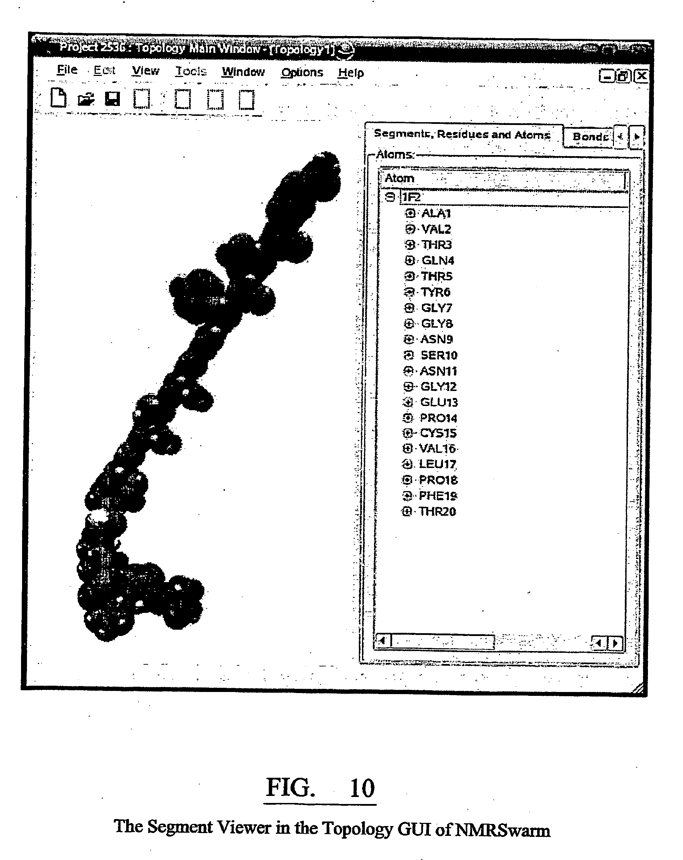

In Figure 10, the icosapeptide segment AVTQTYGGNSNGEPCVLPFT is shown in the segment viewer in the Topology GUI of NMRSwarm. Amongst the tabulated data in the Topology GUI is a cascading interproton NOE viewer/editor.

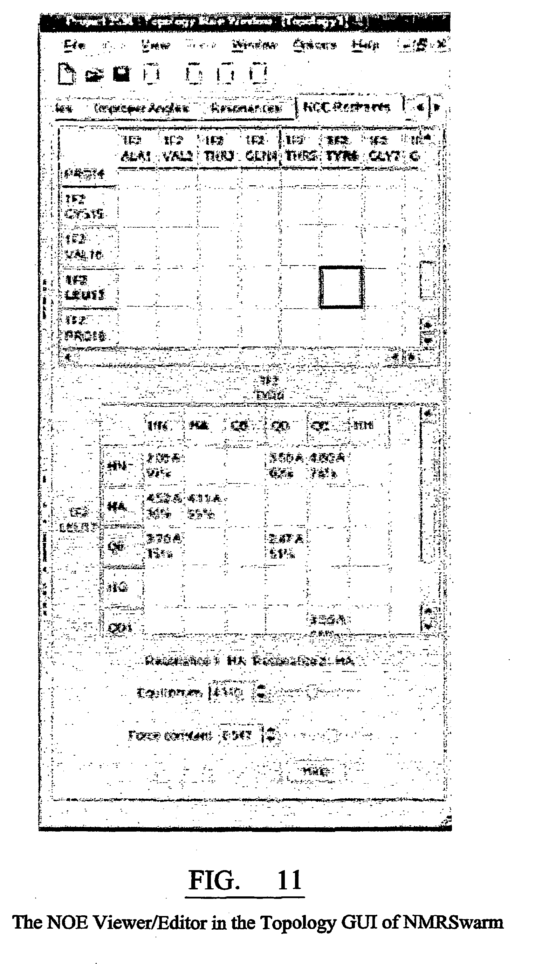

All possible inter- and intraresidue interactions in the topology are shown at the top of the NOE table in Figure 11. When the user clicks on a residue-residue pairing, the lower portion of the table is updated to display all possible inter-proton NOEs for the selected residue pair. Those NOEs, which are switched on, have their equilibrium distance (in Å) and force constant (in %) shown.

Clicking on any of the interproton NOE boxes updates the equilibrium distance and force constant editor sliders at the bottom of the table and allows the user to manually edit these values for the selected NOE.

When the program is performing the swarm intelligence structure calculation, the contents of the NOE table are updates in real time to allow for monitoring of the progress of the NOE assignment process.

## Swarm Interface

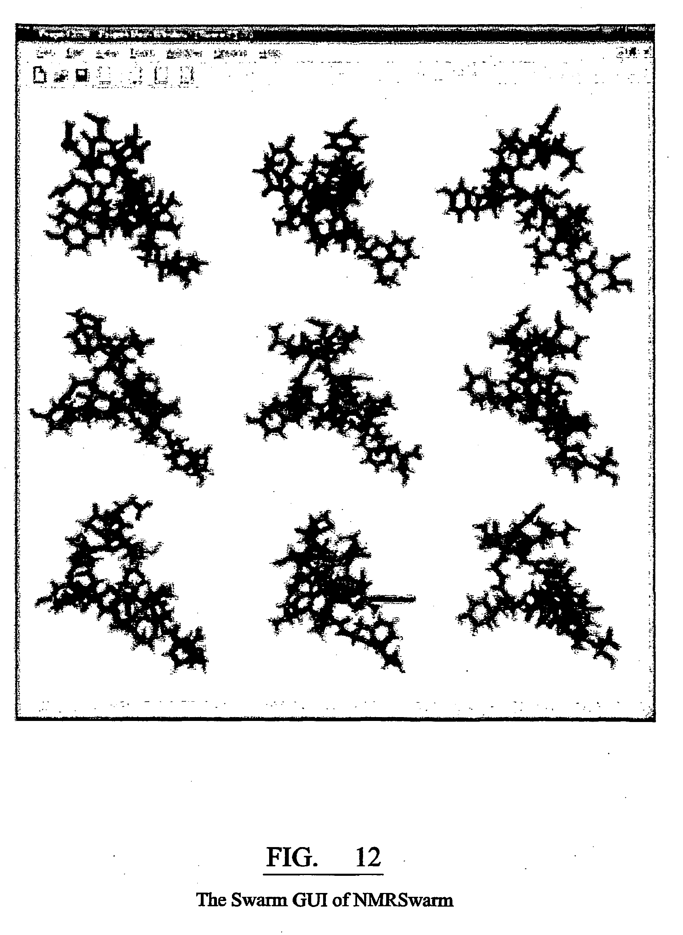

The Swarm multi-document GUI of NMRSwarm features an OpenGL viewer, which shows a real-time display of the molecular dynamics simulations and allows for independent rotation, translation and selection of the molecular agents. Pull-down menus allow the user to start and stop the molecular dynamics and NOESY back-calculation loops (i.e. the swarm intelligence calculations), and to load or save coordinate files in a PDB format. Figure 12 shows a nine-agent swarm of the icosapeptide AVTQTYGGNSNGEPCVLPFT in the "tube" viewing style. The agents have undergone 25ps of swarm intelligence based structure determination coupled to a two-dimensional 1H-1H NOESY spectrum.

## NMR Conditions Interface

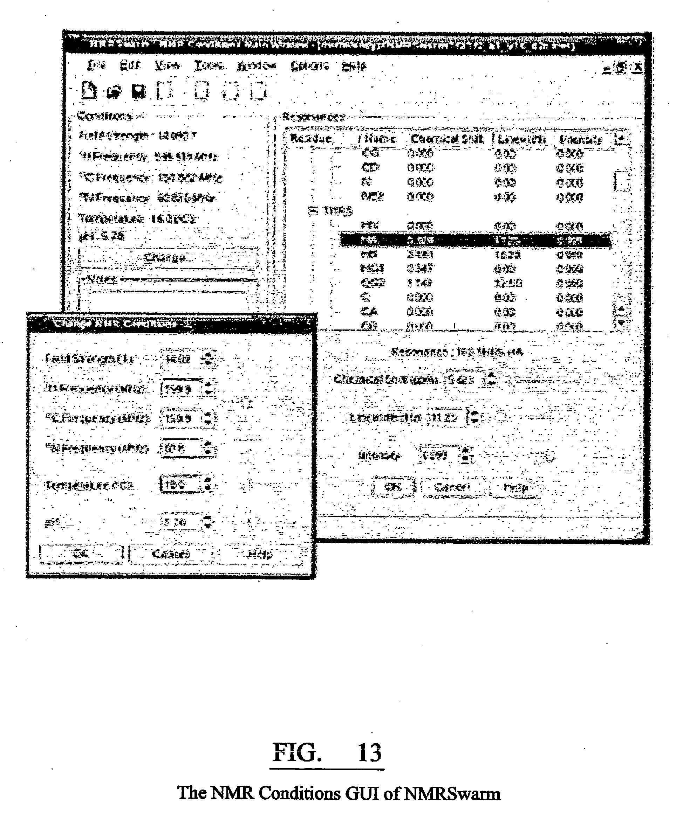

The NMR Conditions multi-document GUI of NMRSwarm shown in Figure 13 allows the user to create, edit, load, save and delete NMR conditions. Conditions are loaded from file or generated *ab initio* using a pre-existing Topology. A pop-up menu allows the user to edit the field strength, pH and temperature of the conditions, whilst an interactive list view tree provides a convenient means of modifying the chemical shifts, linewidths and intensities of selected resonances.

## NMR Spectrum Interface

The NMR Spectrum multi-document GUI of NMRSwarm allows the user to load NMR spectra, couple them to a topology and view the progress of the swarm calculation in real time from the level of agreement between the experimental and back-calculated or restraint intensities.

Owing to the difficulty of comparing peak intensities in traditional orthographic contour plots of NMR spectra (which is usually done by "contourcounting"),

NMRSwarm offers a three-dimensional perspective view of the spectra in addition to the orthographic projection. The user may zoom, rotate and pan through the spectrum and adjust the contour level, the contour level multiplier and the number of contours. This allows to user to easily identify correctly assigned NOEs as well as those that are over- or under-constrained. In addition, errors in resonance chemical shift and/or linewidth may be seen.

A region of a 2D NOESY spectrum is shown is perspective mode with experimental NOE crosspeaks shown in green and NOE restraint crosspeaks in red. Where crosspeaks appear yellow, such as that marked with an asterisk (*), there is an excellent agreement between the experimental data and NOE restraint distance.

**Software Implementation**

*MOLECULAR TOPOLOGY CLASS*

***Generated from CNS***

A molecular topology, which defines the covalent structure of the molecule, was generated for each protein using the program *CNS* version 1.0 (Brünger *et al.,* 1998) and the residue templates described in the file "topallhdg.pro". The molecular topology is written to an ASCII file in a STAR format.

*Treatment of disulphide bonds*

For those proteins containing disulphide bonds, the cysteine residues were oxidised (by removing the $\gamma$-sulphydryl protons) but no bond or bond angle constraints were applied between the sulphur atoms.

*Input into the NMRSwarm program*

The STAR format molecular topology files generated by CNS are read directly into the NMRSwarm program.

*Molecular Agent*

*Description*

Each molecular agent object contains coordinates, velocities and accelerations for each atom in the molecule (as described by the molecular topology), together with kinetic and potential energy variables.

*Initial coordinates*

Initial randomized coordinates for swarm intelligence structure calculations were produced using the program *CNS* version 1.0 (Brünger *et al.,* 1998) using the protein's molecular topology file. In brief, coordinates of the atoms were randomized and then the covalent structure and local geometry were regularized using the bond length, bond angle and torsional parameters specified in the all-atom forcefield PROLSQ (Linge & Nilges, 1999) but without the application of constraints defining disulphide bonds. Finally, the backbone torsional angles ($\theta$ and $\psi$) were randomized for every residue excluding proline. The multiple initial sets of molecular coordinates were concatenated into an ensemble coordinate file (in Brookhaven PDB format) with each conformer segregated by the MODEL and ENDMDL keywords.

*Coordinate Input and Output in NMRSwarm*

Molecular coordinates are read into and written from NMRSwarm in the Brookhaven PDB ensemble coordinate format.

**Molecular Resonance**

Each molecular resonance object comprises a chemical shift ($\delta$), linewidth ($\lambda$) and occupancy ($\rho$) for a given nucleus (or group of magnetically-identical nuclei) in the molecule for a given set of conditions (temperature, pH, ionic strength, field strength, etc.).

*Measurement of Chemical Shift and Linewidth*

Where possible, the chemical shift and linewidth of each molecular resonance is measured from well-separated, high-intensity crosspeaks in the NOESY spectra. In cases of severe spectral overlap, the chemical shifts and/or linewidths are estimated from analysis of chemically-equivalent resonances in better resolved regions of the spectra. In each case, chemical shifts are documented in parts per million (ppm) to 3 decimal places, and linewidths to the nearest Hz.

*Fractional Occupancy*

The fractional occupancy ($\rho$) of a given resonance in a sample is the proportion of atoms that contain an NMR-active nucleus. For example, a protein ample at chemical equilibrium in 5% $D_2O$/95% $H_2O$ will have solvent-accessible backbone amide groups that are only 95% protonated and thus have a fractional occupancy of 0.95. In the same sample, all non-exchangeable proton resonances will have a fractional occupancy of 1.0.

*Gaussian Resonance Lineshapes*

A Gaussian resonance is described by the continuous probability density function:-

$$f(x) = \frac{\rho}{\sigma\sqrt{2\pi}}e^{-(x-\delta)^2/2\sigma^2} \qquad \text{Eq. 2.1}$$

where $\rho$ is the fractional occupancy of the resonance, $\delta$ is its chemical shift (in ppm), and $\sigma$, the standard deviation of the Gaussian distribution, is given by:-

$$\sigma = \frac{\lambda}{2\omega\sqrt{2\ln 2}} \qquad \text{Eq. 2.2}$$

where $\lambda$ is the linewidth (in Hz) at half-maximal height and $\omega$ is the carrier frequency (in MHz). For each spectral dimension with digital resolution $\zeta$ (Hz/point), each observable resonance is digitized into evenly-distributed discreet points:-

$$g(x_i) = \frac{\rho}{\sigma\sqrt{2\pi}}e^{-(x_i-\delta)^2/2\sigma^2} \qquad \text{Eq. 2.3}$$

where the positive integer $i \leq \dfrac{2\kappa\sigma}{\zeta}$. The constant $\kappa$ determines the degree of coverage of the Gaussian resonance; a value of 3.0 encompasses 99.7% of the total intensity.

*Molecular Resonance Input and Output in NMRSwarm*

Molecular resonances are read into and written from NMRSwarm in a STAR file format.

**NOESY Data**

NOESY spectral data are imported into NMRSwarm in either FELIX or NMRView format. The spectrometer frequency ($\omega$), spectral width (*sw*), reference shift and reference point of each spectral dimension are retrieved from the header of the NOESY file. The field strength ($\Phi$) is supplied by the user. The observable gyromagnetic ratio (y) for each dimension is determined according to the equation:-

$$\gamma = \frac{2\pi\omega}{\Phi} \qquad \text{Eq. 3.1}$$

The spectral intensities are read into memory in a serial format, decomposing the submatrix format in the FELIX and NMRView files.

*Aliasing*

Any molecular resonance that is observable along a particular dimension (according to the gyromagnetic ratio, $\gamma$) but is outside the spectral width is aliased. The degree of aliasing ($\alpha$) for a given point with chemical shift delta is given by:-

$$\alpha = \left| \frac{2\omega(\delta - \delta_{ref})}{N} \right|$$

Eq. 3.2

where $\delta_{ref}$ is the chemical shift at the centre point of the dimension and $N$ is the Nyquist frequency or spectral width (in Hz). Aliased resonances have $\alpha$ values greater than 1.0. For each Gaussian resonance, those digitized points which have odd values of $\alpha$ are negated:-

$$g(x_i) = \begin{cases} \dfrac{\rho}{\sigma\sqrt{2\pi}}e^{-(x_i-\delta)^2/2\sigma^2} & for \quad \alpha(x_i) = 0,2,4\ldots \\[3mm] -\dfrac{\rho}{\sigma\sqrt{2\pi}}e^{-(x_i-\delta)^2/2\sigma^2} & for \quad \alpha(x_i) = 1,3,5\ldots \end{cases}$$

Eq. 3.3

to simulate the folding of peaks seen in experimental NOESY spectra.

*Spectral Crosspeaks*

In *NMRSwarm,* spectral crosspeaks arise from any possible off-diagonal interaction between two or more resonances, regardless of whether any significant intensity is observed in the experimental data. In an *n*-dimensional NOESY spectrum, the Gaussian crosspeak function ($\Gamma_x$) is calculated as the product of the individual Gaussian resonances from each dimension:-

$$\Gamma_x = \prod_{d=1}^{n} f(x)$$

Eq. 3.4

where *f*(x) describes the Gaussian-shaped resonance along dimension *d*.

The set of pixels, $P_x$, in an *n*-dimensional NOESY crosspeak is given by:-

$$\sqrt{\sum_{d=1}^{n}\left(\frac{\delta_d(p)-\delta_d}{\sigma_d}\right)^2} \le \kappa, \ p \in P_S$$

Eq. 3.5

where $\delta_d$ *(p)* is the chemical shift of pixel *p* in dimension *d* (taking any resonance aliasing into account), $\kappa$ is the degree of intensity coverage in any dimension, and $P_S$ is the set of all pixels in the NOESY spectrum. The Gaussian intensity of each pixel, $\Gamma p$, in the crosspeak is calculated from the product of the Gaussian intensities of the resonance point in each dimension:-

$$\Gamma_p = \prod_{d=1}^{n} f(\delta_d(p))$$

Eq. 3.6

*Crosspeak ambiguity*

The degree of ambiguity of a NOESY crosspeak *x* is one determinant of the force constant applied to the NOE restraint during restrained molecular dynamics. The degree of ambiguity, $\mu_x$, is calculated as the relative contribution of the crosspeak to the total spectral intensity underlying that peak, assuming that all NOEs were equally intense:-

$$\mu_x = \frac{\sum\limits_{p \in P_x} |f(\delta(p))|}{\sum\limits_{y \in X_S} \sum\limits_{p \in (P_x \cap P_y)} |f(\delta(p))|}$$

Eq. 3.7

where $X_S$ is the set of all crosspeaks in the NOESY spectrum. Thus a completely unambiguous crosspeak has an $\mu_x$ of 1.0.

*ISPA Back-calculation*

The back-calculated NOESY spectrum $(\Omega_\beta)$ is a weighted composite of all the Gaussian crosspeaks. It is calculated using the isolated spin pair approximation (ISPA) through the summation of all observable interproton NOEs:-

$$\Omega_\beta = \sum\limits_{n \in N} \sum\limits_{x \in X_n} \Gamma_x \sum\limits_{i<j} \frac{1}{r_{ij}^6} \text{Eq.}$$

3.8

where $r_{if}$ is the interatomic distance between protons $i$ and $j$, or the current equilibrium distance in the interproton NOE restraint, $N$ is the set of NOEs observable in the spectrum, and $X_n$ is the set of crosspeaks arising from NOE n.

*NOESY Calibration*

Each back-calculated NOESY spectrum is calibrated by linear least-squares fit to the experimental spectrum yielding the scaling factor $m_S$:-

$$m_S = \frac{\overline{\varepsilon_p \beta_p}}{\overline{\varepsilon_p^2}}, p \in P_S$$

Eq. 3.9

where $\varepsilon_p$ and $\beta_p$ are the experimental and back-calculated intensities of pixel $p$, respectively, and $P_S$ is the set of unmasked pixels in the NOESY spectrum. The correlation coefficient for this straight line fit is given by:-

$$\rho_S = \frac{\overline{\varepsilon_p \beta_p} - \overline{\varepsilon_p} . \overline{\beta_p}}{\sigma(\varepsilon_p) \sigma(\beta_p)}, p \in P_S$$

Eq. 3.10

where $\sigma(\varepsilon_p)$ and $\sigma(\beta_p)$ are the standard deviations in the experimental and back-calculated intensities, respectively. During the course of the structure calculation, the $m_S$ scaling factors that give the best correlations to the experimental data (i.e. highest $\rho_S$) are recorded for each spectrum for subsequent $X^2$ crosspeak analysis.

*NOESYMasks*

The diagonal of the NOESY spectrum and any regions that contain significant experimental artefacts can be disqualified from involvement in back-calculation and NOE calibration through the use of a binary mask. Any pixel whose mask bit is set is ignored in the NOESY back-calculation and calibration. Any crosspeak that contains a masked pixel is disqualified from involvement in NOE restraints. Any crosspeak that is entirely comprised of masked pixels is removed.

*Intensity Output*

Back-calculated NOESY spectra are output in either a FELIX or NMRView format.

*The Potential Energy Function*

In *NMRSwarm,* the potential energy function, $E_{potential}$, describes the energy of the molecule(s) as a function of the atomic coordinates. It contains conformational (geometric), non-bonded and experimental interaction energy terms:-

$$E_{potential} = E_{bond} + E_{angle} + E_{dihedral} + E_{improper} + E_{vdw} + E_{NOE} \qquad \text{Eq. 4.1}$$

*The Geometric Energy Functions*

A harmonic approximation is used to account for deformations in bond length, bond angles, chirality and planarity in the molecular structure. The covalent bond energy, $E_{bond}$, is given by:-

$$E_{bond} = w_{bond} \sum_{bonds} k_{bond} (r - r_0)^2 \qquad \text{Eq 4.2}$$

where $r$ is the interatomic distance, $k_{bond}$ is the bond force constant and $r_0$ is the equilibrium bond length. The three-atom bond angle energy, $E_{angle}$, is described by:-

$$E_{angle} = w_{angle} \sum_{angles} k_{angle} (\theta - \theta_0)^2 \qquad \text{Eq 4.3}$$

where $\theta$ is the three-atom bond angle, $k_{angle}$ is the force constant and $\theta_0$ is the equilibrium value for the angle. The planarity and chirality of four-atom groups $(i,j,k,l)$ are maintained through "improper" torsion angles between the planes $ijk$ and $jkl$:-

$$E_{improper} = w_{improper} \sum_{impropers} k_{improper} (\phi - \phi_0)^2 \qquad \text{Eq 4.4}$$

where $\varphi$ the actual torsion angle, $k_{improper}$ is the force constant and $\varphi_0$ is the equilibrium torsion angle.

The dihedral angle term, $E_{dihedral}$, describes multi-minimum torsion potentials as a cosine expansion:-

$$E_{dihedral} = w_{dihedral} \sum_{dihedrals} k_{dihedral} (1 + \cos(n\phi + \delta))^2 \qquad \text{Eq 4.5}$$

where $\varphi$ the actual torsion angle, $k_{dihedral}$ is the force constant and $\delta$ is the phase shift on the torsion angle.

The force constants, equilibrium values and phase shifts for the above energy terms are as listed in the *CNS* parameter file parallhdg5.1.pro. The weights on the geometric terms *($w_{bond}$, $w_{angle}$,...)* are usually held equal and constant at 1.0 throughout the structure calculation.

*The Non-bonded (Van der Waals) Energy Function*

The non-bonded energy term, $E_{vdw}$, is a soft, purely repulsive function without attractive or electrostatic components. Interactions between bonded atoms, and those between atoms that are bonded to a common third atom are excluded from $E_{vdw}$. Interactions between atoms that are connected through three covalent bonds (so called 1-4 non-bonded interactions) are computed using modified equilibrium distances. Non-bonded energy terms are truncated at an interatomic distance $r_i$ for atom pairs that are too close to each other to minimize numerical instabilities in the case of strained initial coordinates or close contacts during high simulation temperatures. Thus the non-bonded energy is given by:-

$$E_{vdw} = w_{vdw}\left(\sum_{vdws} \max\left(0, r_{\min} - \max(r, r_i)\right)^4 + \sum_{1,4-vdws} \max\left(0, r_{\min 1,4} - \max(r, r_i)\right)^4\right) \quad \text{Eq. 4.6}$$

where $r$ is the interatomic distance, $r_{\min} = \sigma \sqrt[6]{2}$ and $r_{\min 1,4} = \sigma_{1,4}\sqrt[6]{2}$. For interactions between identical atom types, the values of $\sigma$ and $\sigma_{1,4}$ are as defined in the PROLSQ option in the *CNS* parameter file parallhdg5.1.pro. Between different atom types, the following combination rules are used:-

$$\sigma_{ij} = \frac{\sigma_{ii} + \sigma_{jj}}{2} \quad \text{and} \quad \sigma_{1,4ij} = \frac{\sigma_{1,4ii} + \sigma_{1,4jj}}{2} \quad \text{Eq. 4.7}$$

The weighting on the non-bonded energy term, $w_{vdw}$, is regulated during the structure calculation to allow or inhibit close atom contacts.

*The NOE Energy Function*

The NOE energy function, $E_{NOE}$, takes the form of a pseudo-harmonic potential with a high-end asymptote:-

$$E_{NOE} = k_{NOE}\left(\max(0, r_l - r)^2 + \max(0, r - r_u) \times \max(0, \min(r_b, r) - r_u)\right) \quad \text{Eq. 4.8}$$

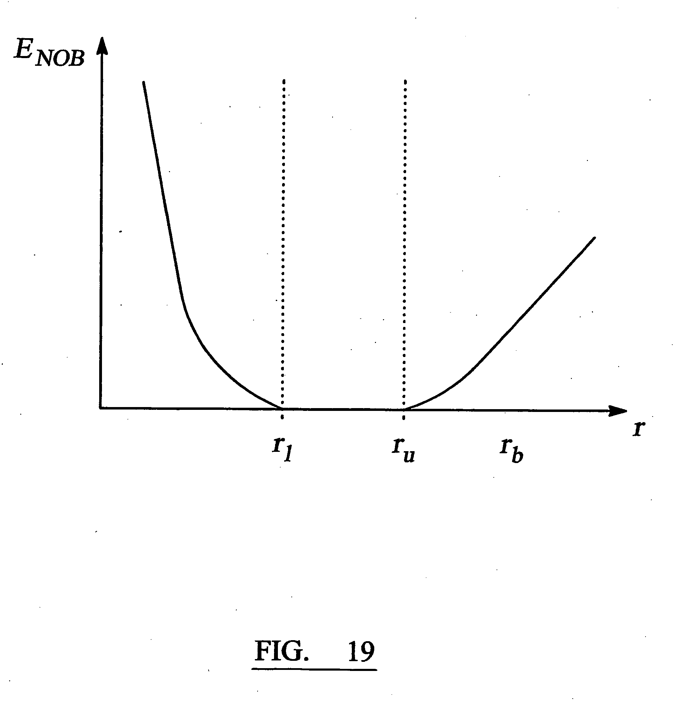

where $k_{NOE}$ is the individual NOE force constant, $r_l$ is the lower bound on the flat well of the potential, $r_u$ is the upper bound, $r_b$ is a barrier above which a linear asymptote is applied. The pseudo-harmonic $E_{NOE}$ potential with a high-end asymptote is shown in Figure 19. This asymptote reduces numerical instabilities for those interproton distances that deviate dramatically from the upper bound.

The values of $k_{NOE}$, $r_l$ and $r_u$ are specific to each NOE and are determined on-the-fly during the molecular structure calculation. The value of $r_b$ (the "NOE barrier") is constant for all NOE restraints (typically 5.0 Å). When both resonances are single protons, r is the interproton distance, otherwise an $r^6$ summed distance is calculated for all *i-j* proton pairings:-

$$r = \left(\sum_{i,j} \frac{1}{r_{ij}^6}\right)^{-\frac{1}{6}} \quad \text{Eq. 4.9}$$

*Restrained Molecular Dynamics/Simulated Annealing*

*Cartesian Molecular Dynamics*

Molecular dynamics consists of solving Newton's equations of motion:-

$$m_i \frac{d^2\mathbf{r}_i}{dt^2}(t) = -\frac{d\left(E_{potential}\right)}{d\mathbf{r}_i} \quad \text{Eq. 5.1}$$

where the index *i* runs through all atoms in the molecule. *NMRSwarm* uses a modified cartesian molecular dynamics algorithm which incorporates a frictional term that controls the temperature of the system, which is described in Berendsen *et al.,* 1984 as:

$$m_i \frac{d^2 \mathbf{r}_i}{dt^2}(t) = -\frac{d\left(E_{potential}\right)}{d\mathbf{r}_i} - m_i b_i \frac{d\mathbf{r}_i}{dt}(t) \qquad \text{Eq. 5.2}$$

where the friction coefficient $b_i$ (units of ps$^{-1}$) is computed from the equation:-

$$b_i = b_i^I \left( \frac{T_0}{T} - 1 \right) \qquad \text{Eq. 5.3}$$

where $b_i^I$ is an atom-specific friction constant, $T_0$ is the target temperature and $T$ is the current temperature which is given by:-

$$T = \frac{1}{n_{\text{deg}} k_B} \sum_i m_i \left| \frac{d r_i}{dt} \right|^2 \qquad \text{Eq. 5.4}$$

*MD Integrator : Verlet leapfrog*

Solving Newton's equation of motion requires a numerical procedure for integrating the differential equation. A standard method for solving ordinary differential equations such as this is the finite-difference approach. In this approach, the molecular coordinates and velocities at time $t + \Delta t$ are obtained (to a sufficient degree of accuracy) from the molecular coordinates and velocities at an earlier time $t$. In *NMRSwarm,* Cartesian molecular dynamics is performed using the Verlet leap-frog integrator (Verlet, 1967), so called for its half-step scheme: the velocities are evaluated at the mid-point of the position evaluation and vice versa:-

$$\mathbf{r}_{n+1} = \mathbf{r}_n + \frac{\partial \mathbf{r}_{n+1/2}}{\partial t} \Delta t \qquad \text{Eq. 5.5}$$

$$\frac{\partial \mathbf{r}_{n+1/2}}{\partial t} = \frac{\partial \mathbf{r}_{n-1/2}}{\partial t} + \frac{\partial \left(E_{potential}\right)_n}{\partial t} \times \frac{\Delta t}{m} \qquad \text{Eq. 5.6}$$

The choice of the time interval $\Delta t$ is a trade-off between economy and accuracy.

*Simulated Annealing*

Restrained molecular dynamics simulations have a much larger radius of convergence than techniques involving distance geometry and conjugate-gradient minimization because, due to the kinetic energy of the system, they are able to overcome the barriers surrounding local potential energy minima. This ability may be enhanced by elevating the temperature (thus increasing the kinetic energy) and by weakening the van der Waals repulsion (thus diminishing the energy barriers) in a procedure known as "simulated annealing". In this procedure the system is driven towards the global potential energy minimum by thermal coupling to a "heat bath": increased kinetic energy, resulting from random conformational changes which reduce the potential energy, is dissipated to the bath making the reverse conformational transition very unlikely. Following the high temperature dynamics, the system is cooled and the van der Waals repulsion restored, effectively trapping the system in the global potential energy minimum.

### Update of NOE restraints

*NOE Contributions*

Each NOE can give rise to one or more crosspeaks in multiple NOESY spectra. Therefore, NOE restraints are constructed from multiple contributions, each arising from a separate crosspeak. Each crosspeak contribution has its own ambiguity factor ($\mu_x$) which depends on the degree of spectral overlap, its own equilibrium distance ($r_0$) that best fits the experimental data, and its own force constant ($k_{NOE}$) that reflects the degree of fit to the experimental data.

Since the least ambiguous crosspeaks are the most reliable source of information, the equilibrium distance for NOE restraint $n$ is calibrated by the weighted average:-

$$r_0 = \sum_{x \in X_N} \frac{\mu_x r_{0x}}{\sum_{y \in X_N} \mu_y} \qquad \text{Eq. 6.1}$$

where $X_N$ is the set of crosspeaks that arise from NOE $n$. The upper and lower bounds on the equilibrium distance, $r_u$ and $r_l$ (see Section 3._...), are set at a fixed percentage above and below $r_0$, respectively.

Similarly, the force constant for the NOE restraint $n$ is given by the weighted mean:-

$$k_{NOE} = \sum_{x \in X_N} \frac{\mu_x k_{NOEx}}{\sum_{y \in X_N} \mu_y} \qquad \text{Eq. 6.2}$$

The force constant for NOE contribution $x$ reflects the degree of ambiguity of the crosspeak, the level of agreement with the experimental data, and the distance of $r_0$ beyond the NOE barrier $r_b$, and is given by:-

$$k_{NOEx} = \frac{\mu_x^2 \rho_x^4}{1 + \max(0, r_0 - r_b)/a} \qquad \text{Eq. 6.3}$$

where $a$ is a constant and $\rho_x$, the correlation coefficient over the crosspeak is given by:-

$$\rho_P = \frac{\overline{\varepsilon_p \beta_p} - \overline{\varepsilon_p} . \overline{\beta_p}}{\sigma(\varepsilon_p) \sigma(\beta_p)}, p \in P_x \qquad \text{Eq. 6.4}$$

where $\sigma(\varepsilon_p)$ and $\sigma(\beta_p)$ are the standard deviations in the experimental and back-calculated intensities, respectively, over the set of crosspeak pixels $P_x$.

*NOE Updates*

Following back-calculation of a NOESY spectrum from the atomic coordinates, the degree of fit of each crosspeak, $x$, to the experimental data is evaluated through a $\chi^2$ squared test:-

$$\chi_x^2 = \sum_{p \in P_x} (\varepsilon_p - m_S \beta_p)^2, x \in X \qquad \text{Eq.6.5}$$

where $\varepsilon_p$ and $\beta_p$ are the experimental and back-calculated intensities of pixel p, respectively, and $m_S$ is the calibration coefficient for the entire unmasked NOESY spectrum.

Any crosspeak which shows an improved fit (i.e. lower $\chi^2$) to the experimental data has its associated equilibrium distance ($r_0$) updated to the current (r^6 summed) interproton distance. The new $\chi^2$ value (which is set to infinity initially) is memorised as a record of the quality of the fit.

*NOE Memory Degradation*

Incorrect distance calibrations of NOE contributions that happen to fit well with the experimental data (i.e. have a low $\chi^2$) must be "forgotten" to prevent misfolding of the molecule and the subsequent erroneous calibration of other interproton distances. This is achieved through degradation of the memorised degree of fit to the experimental data:-

$$\frac{d(\chi^2)}{dt} = \tau(\chi^2), \quad \tau \geq 0 \qquad\qquad \text{Eq. 6.6}$$

where $\tau$ is the NOE memory decay constant (units of ps$^{-1}$). Therefore, NOE distance calibrations are transient during the course of the structure calculation process and are continuously updated based on conformational experience.

*NOE Restraint Combination*

In order to further reduce the influence of spurious interproton distance calibrations that may arise during the swarm intelligence structure calculations, those NOE restraints with an equilibrium distance ($r_0$) less than the barrier ($r_b$) are combined. In brief, the NOEs are sorted with respect to $r_0$ and neighbouring pairs in the list are pooled into combined restraints. Thus, $n - 1$ combined NOE restraints are generated from $n$ individual NOEs. Each combined NOE restraint is applied in the molecular dynamics as an ambiguous restraint with an $r^{-6}$ summed distance.

*Floating Chirality*

Distinct but non-stereospecifically assigned prochiral resonances (e.g. the methyl resonances of isopropyl groups) are arbitrarily assigned to either the pro-*R* or pro-*S* moiety in the assignment lists. At 1ps intervals during the structure calculation, the stereoassignments of a constant proportion (typically 10%) of randomly chosen prochiral groups were swapped for each agent. Only those exchanges that result in an improved fit to the experimental data (as judged by the sum of $\chi^2$ differences for all related NOESY crosspeaks) are accepted. The best prochiral assignments are applied to the NOE restraints during the molecular dynamics.

**Assessment of Final Structure Quality**

The quality of the experimental restraints is determined from the correlation coefficient between a back-calculated restraints NOESY spectrum (a spectrum that would be produced if all interproton distances matched those of the restraints) and the experimental data. The level of agreement between the experimental restraints and the molecular structures is determined by the root mean square deviation (rmsd) from the equilibrium interproton distances. The stereochemical quality of the final structures was determined by ramachandran analysis using the program PROCHECK-NMR.

However, other programs may be used when determining the stereochemical quality of final structures.

**Materials**

**Chemical Reagents**

Deuterium oxide was supplied by CK Gas Products Ltd. (Wokingham, UK). Miili-Q water was supplied by Millipore (Watford, UK). All other chemical reagents were supplied by Sigma (Poole, UK).

**The $^1$F2 Module from Fibronectin**

Uniformly $^{15}$N-labelled $^1$F2 module, corresponding to residues A315-T374 of mature human fibronectin, was produced from the methylotrophic yeast *Pichia pastoris* as described previously (Pickford *et al.,* 1997; Bright *et al.,* 2000). Samples for NMR spectroscopy were dissolved to a concentration of 1.5mM in either 5% D$_2$O/95% H$_2$O with 20mM potassium phosphate pH 6.0, or 99.96% D$_2$O with 20mM potassium phosphate pH 6.0 (pH meter uncorrected for deuterium). $^1$H and $^{15}$N chemical shift assignments for the $^1$F2 module at pH6.0 and 25°C have been published previously (Smith et al., 2000) along with a solution structure determined by manual assignment of NOEs (Pickford *et al.,* 1997).

### The FERM3 Module from Talin

Uniformly $^{15}$N-labelled FERM3 module, corresponding to residues 309-405 of mature mouse talin containing the point mutation C336S, was produced from *Escherichia coli* in M9 minimal media by Dr.Kate Wegener (Oxford University) as previously described (de Pereda JM *et al.,* 2005). Samples for NMR spectroscopy were dissolved to a concentration of 1.5mM in either 5% $D_2O$/95% $H_2O$, or 99.96% $D_2O$. The samples were buffered with 50mM potassium phosphate to pH 6.1 (pH meter uncorrected for deuterium) and contained 100mM NaCl. These conditions were used previously for $^1$H and $^{15}$N chemical shift assignments of the module at 25°C (de Pereda JM *et al.,* 2005). No. solution structure has been determined to date. However, a crystal structure of a chimeric complex between FERM3 and a peptide from PIPKI has been published recently (de Pereda *et al.,* 2005).

### NMR Methods

### Spectrometers

All NMR spectra were recorded on home-built GE-Omega spectrometers fitted with triaxial gradient, triple-resonance probes and operating at 11.4 T (500MHz for $^1$H, 50MHz for $^{15}$N), 14.1 T (600MHz for $^1$H, 60MHz for $^{15}$N) or 17.6 T (750MHz for $^1$H 76MHz for $^{15}$N). Pulsed field gradients were employed for coherence selection and water suppression $^{15}$N decoupling during acquisition was carried out using an 833 Hz GARP1 decoupling field NMR spectra were recorded at 25°C for the $^1$F2 and FERM3 modules.

### NOESY Data Acquisition

Three NOESY spectra were recorded on each sample, a two-dimensional (2D) NOESY in 5% $D_2O$/95% $H_2O$, a 2D NOESY in 99.6% $D_2O$, and a three-dimensional (3D) $^{15}$N-edited NOESY in 5% $D_2O$/95% $H_2O$. In each case a relaxation delay of 1s was used and the NOE mixing time was 50ms. Spectra on the $^1$F2 module and the FERM3 module were recorded with the acquisition parameters listed in Tables 2 and 3 respectively.

**Table 2.** Acquisition parameters for NOESY experiments on the $^1$F2 module (14.1T).

| Experiment | 2D NOESY in 5% $D_2O$/95% $H_2O$ | | 2D NOESY in 99.96% $D_2O$ | | 3D $^{15}$N-edited NOESY in 5% $D_2O$/95% $H_2O$ | | |
|---|---|---|---|---|---|---|---|
| Dimension | Direct $^1$H | Indirect $^1$H (NOE) | Direct $^1$H | Indirect $^1$H (NOE) | Direct $^1$H | Indirect 15N | Indirect $^1$H (NOE) |
| Spectral Width (Hz) | 6666.7 | 6666.7 | 6666.7 | 6666.7 | 6666.7 | 800 | 6666.7 |
| Dwell time ($\mu$s) | 150 | 150 | 150 | 150 | 150 | 625 | 150 |
| Complex points | 1024 | 512 | 1024 | 512 | 512 | 24 | 256 |
| Acquisition time (ms) | 153.6 | 76.8 | 153.6 | 76.8 | 76.8 | 15.0 | 38.4 |

**Table 3.** Acquisition parameters for NOESY experiments on the FERM3 module.

| Experiment | 14.1T 2D NOESY in 10% $D_2O$/90% $H_2O$ | | 14.1T 2D NOESY in 99.96% $D_2O$ | | 11.8T 3D $^{15}$N-edited NOESY in 10% $D_2O$/90% $H_2O$ | | |
|---|---|---|---|---|---|---|---|
| Dimension | Direct $^1$H | Indirect $^1$H (NOE) | Direct $^1$H | Indirect $^1$H (NOE) | Direct $^1$H | Indirect $^{15}$N | Indirect $^1$H (NOE) |
| Spectral Width (Hz) | 12500 | 6666.7 | 12500 | 6666.7 | 12500 | 1493 | 6993 |
| Dwell time ($\mu$s) | 80 | 150 | 80 | 150 | 80 | 335 | 143 |

(continued)

| Experiment | 14.1T 2D NOESY in 10% D$_2$O/90% H$_2$O | | 14.1T 2D NOESY in 99.96% D$_2$O | | 11.8T 3D $^{15}$N-edited NOESY in 10% D$_2$O/ 90% H$_2$O | | |
|---|---|---|---|---|---|---|---|
| Complex points | 1024 | 1024 | 1024 | 1024 | 1024 | 30 | 170 |
| Acquisition time (ms) | 81.9 | 153.6 | 81.9 | 153.6 | 81.9 | 10.1 | 24.3 |

### NOESY Data Processing

Processing of NOESY data was performed using the program NMRPipe (Delaglio *et al.,* 1995). All $^1$H dimensions were processed with Lorentzian to Gaussian transformations to improve the resonance lineshape and enhance resolution (although other lineshapes and window functions could be used equally well). The $^1$H dimensions of the 2D spectra were zero-filled to 1024 complex points to improve the digital resolution and then Fourier transformed and phased. The $^1$H dimensions of the 3D NOESY spectra were processed in the same way except that zero-filling was performed to 512 complex points only. The 3D NOESY $^{15}$N dimensions were doubled in acquisition time through the use of linear prediction followed by the application of a Lorentzian-Gaussian window function, Fourier transformation and phasing. Spectra were referenced to an external 2,2-dimethyl-2-silapentane-5-sulfonate (DSS) sample at 0 ppm ($^1$H), with indirect referencing in the $^{15}$N dimension using a $^{15}$N/$^1$H frequency ratio of 0.101329118 (Wishart *et al.,* 1995).

### NOESY Data Masks

All NOESY spectral points within 0.1ppm of the $^1$H-$^1$H diagonal are exempt from the back-calculation and correlation stages as these intensities cannot be determined using the isolated spin pair approximation (ISPA). In addition, those intraresidue NOE crosspeaks exhibiting strong coupling interactions (and hence non-gaussian peakshapes), and spectral artefacts arising from truncation of the time-domain signal are also masked out. Any NOE crosspeak that resides in such a masked out region is ignored during the NOE restraint calibration stage.

### Swarm Intelligence Structure Calculations

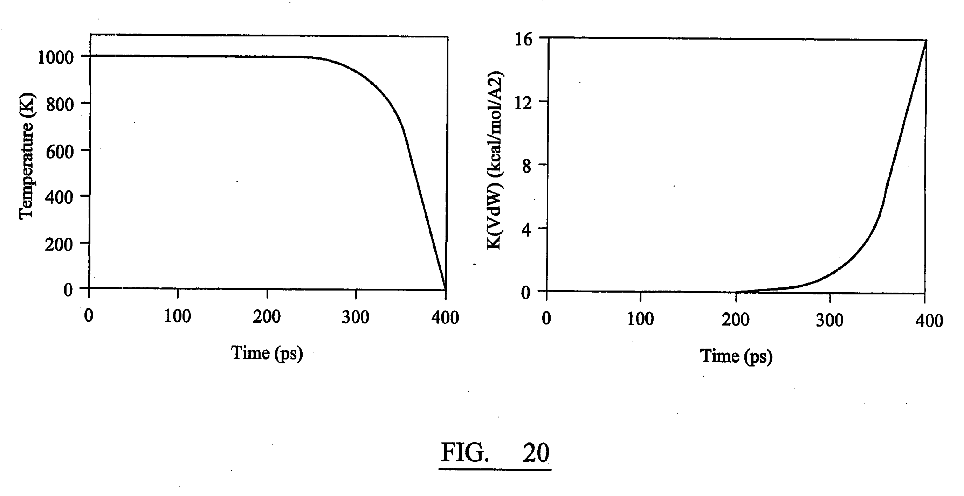

An identical simulated annealing protocol was used for both swarm intelligence structure calculations. The only parameters that were varied during the course of the annealing were the bath temperature and the force constant on the Van der Waals repulsion. Both of these were controlled with half-sigmoidal ramps with points of inflexion at 400ps, the end of the simulation. In Figure 20, the half-sigmoidal bath temperature and Van der Waals force constant ramps applied during the NMR swarm simulated annealing structure calculations.

### Results

### The $^1$F2 module from fibronectin

The $^1$F2 module solution structure was determined from a 20-agent swarm intelligence biomolecular structure calculation staring from randomised backbone conformations.

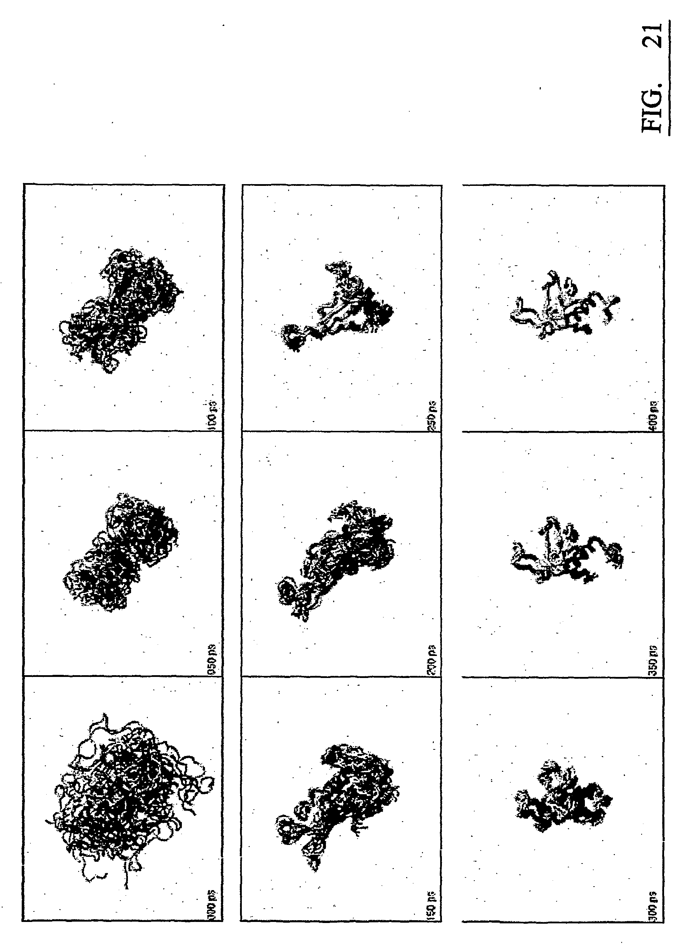

Figure 21 shows the evolution of the fibronectin $^1$F2 module swarm. The snapshots are from the 400ps 20-agent swarm intelligence structure determination of the human fibronectin $^1$F2 module with the β-strands coloured cyan and the α-helices red. At each time point, the molecules have been rotated with the same transformation that best overlays the backbone heavy atoms (N, C$_\alpha$ and C) at 400ps.

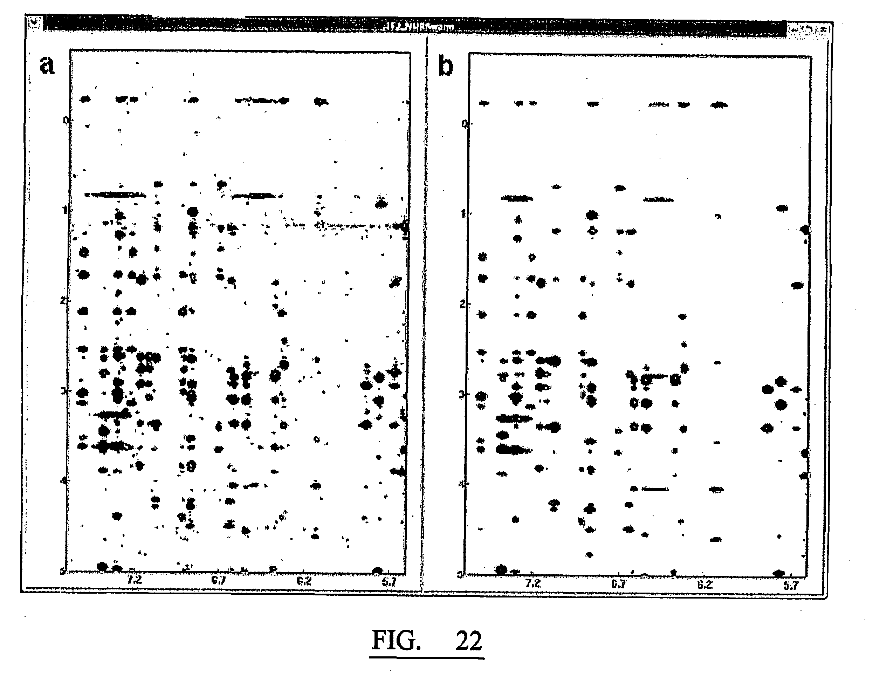

In Figure 22, a comparison between experimental and back-calculated $^1$F2 NOESY data is shown. In Fig.22 (a), an excerpt from the experimental 50ms D$_2$O NOESY spectrum of $^1$F2 showing many of the aromatic (x-axis) to aliphatic (y-axis) NOEs that characterize the module fold and in Fig. 22(b) a NOESY spectrum back-calculated using an isolated spin pair $r_0^{-6}$ summation from the applied NOE restraints at time 400ps.

At the end of the annealing, 13 of the agents were selected are representative of the $^1$F2 module fold on the basis of their low potential energy. These agents are in close agreement with the previously-determined NMR structure of $^1$F2 (Pickford *et al.,* 1997) as shown by their backbone heavy atom (N, C□ and C) root mean square deviation (rmsd) of 0.91Å.

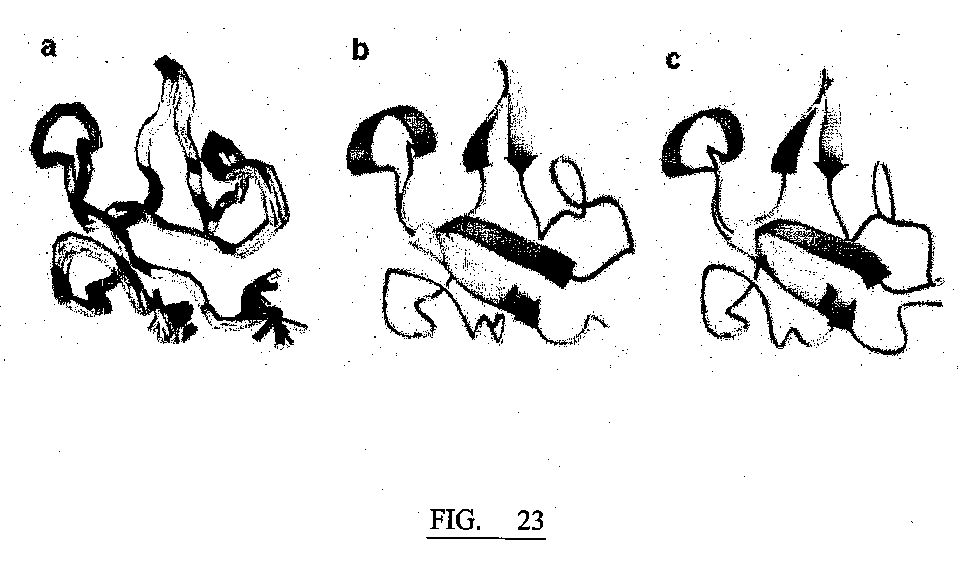

In Figure 23, a comparison of the Swarm Intelligence NMR structure of $^1$F2 with that derived previously from solution NMR data is made. In Fig. 23(a), an overlay of the selected $^1$F2 molecular agents at the end of the swarm intelligence simulated annealing is shown. The average coordinates from the agents are shown as a ribbon representation in Fig 23(b). Fig 23(c) shows the solution NMR structure of the [1]F2 module as determined previously using the traditional iterative assignment scheme (Pickford *et al.*, 1997).

*The critical role of cooperativity in swarm intelligence structures calculations*

The success of the swarm intellgence strategy to biomolecular structure determination is due to the collective "intelligence" of the communicating agents. If this communication is absent during the parallel simulations then the strategy fails, since the isolated agents are incapable of searching sufficient conformational space to find the correct structure. Thus, traditional iterative assignment schemes, which employ serial, isolated structure calculations can never reach the level of convergence reported here for our swarm intelligence strategy.

*The FERM3 module from talin*

In order to further demonstrate the applicability of the swarm intelligence strategy, the FERM3 module from mouse talin was determined from a 20-agent swarm intelligence biomolecular structure calculation starting from randomised backbone conformations.

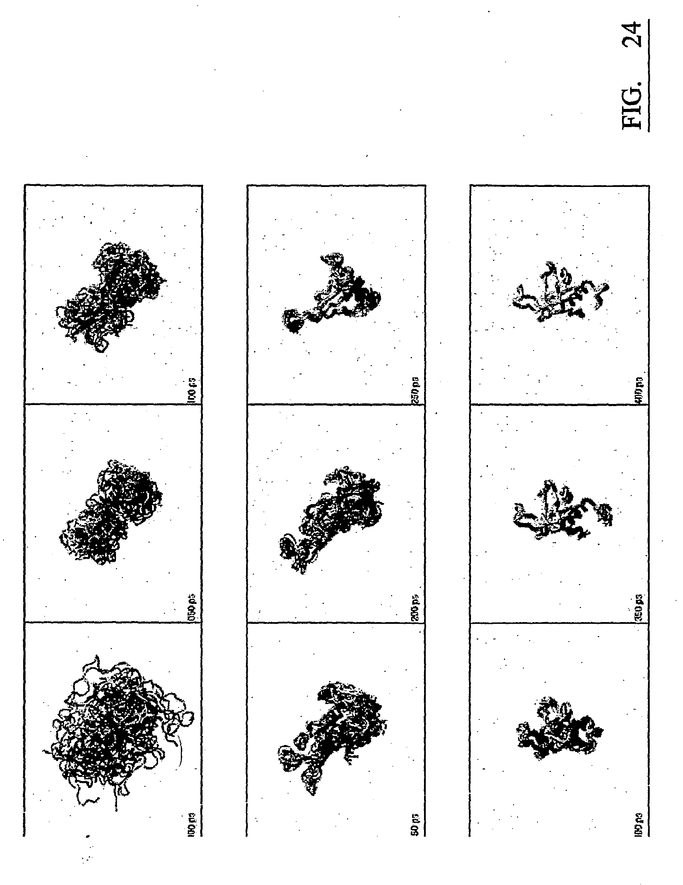

In Figure 24, the Evolution of the FERM3 swarm can be appreciated. It shows snapshots from the 400ps 20-agent swarm intelligence structure determination of the FERM3 module from mouse talin with the β-strands coloured cyan and the α-helices red. At each time point, the molecules have been rotated with the same transformation that best overlays the backbone heavy atoms (N, $C_\alpha$ and C) at 400ps.

At the end of the annealing, 16 of the agents were selected as representative of the FERM3 module fold on the basis of their low potential energy. These agents are in close agreement with the coordinates of the FERM3 module in the previously-determined crystal structure of the FERM3-PIPKI□ (de Pereda *et al.*, 2005) as shown by their backbone heavy atom (N, Cα and C) root mean square deviation (rmsd) of 1.04Å.

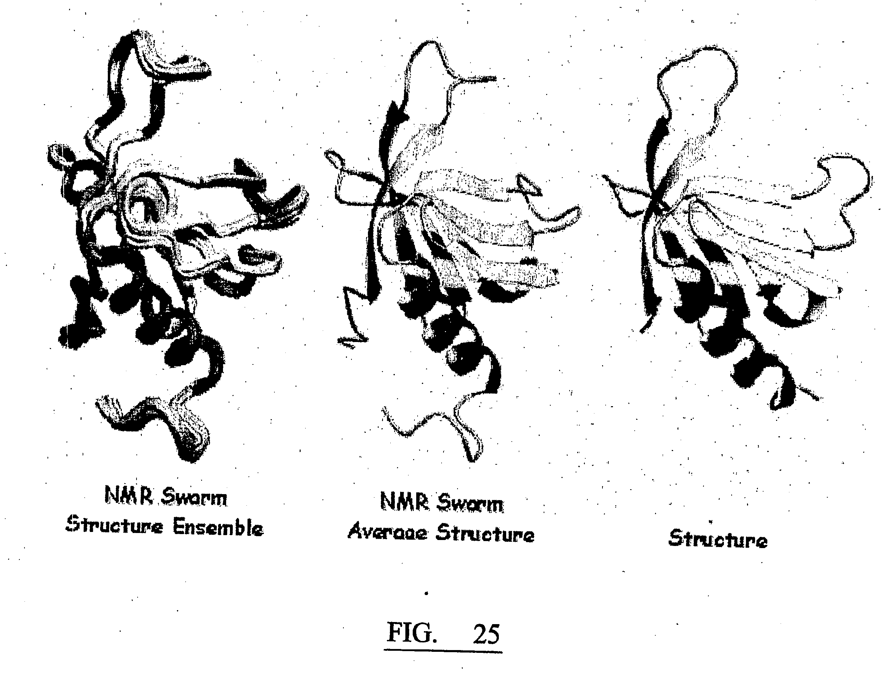

In Fig 25, a comparison of the Swarm Intelligence NMR structure of FERM3 with that derived from X-ray crystallography is shown. Fig 25(a) depicts the overlay of FERM3 molecular agents at the end of the swarm intelligence simulated annealing. Fig 25(b) depicts the average coordinates from the selected agents are shown as a ribbon representation. Fig 25 (c) The crystal structure of the FERM3 module (de Pereda *et al.*, 2005).

**References**

- Berendsen, H.J.C., Postma, J.P.M., van Gunsteren, N.F., DiNola, A. and Haak, J.R. (1984). Molecular dynamics with coupling to an external bath. J. Chem Phys. 81, 3684-3690.

- Bright JR, Pickford AR, Potts JR, Campbell ID. Methods Mol Biol. 2000;139:59-69. Preparation of isotopically labeled recombinant fragments of fibronectin for functional and structural study by heteronuclear nuclear magnetic resonance spectroscopy.

- F. Delaglio, S. Grzesiek, G. W. Vuister, G. Zhu, J. Pfeifer and A. Bax: NMRPipe: A multidimensional spectral processing system based on UNIX pipes. J. Biomol. NMR. 6, 277-293 (1995).

- De Pereda JM, Wegener KL, Santelli E, Bate N, Ginsberg MH, Critchley DR, Campbell ID, Liddington RC. J Biol Chem. 2005 Mar 4;280(9):8381-6. Structural basis for phosphatidylinositol phosphate kinase type Igamma binding to talin at focal adhesions.

- Pickford AR, Potts JR, Bright JR, Phan I, Campbell ID. Structure. 1997 Mar 15;5(3):359-70. Solution structure of a type 2 module from fibronectin: implications for the structure and function of the gelatin-binding domain.

- Smith SP, Hashimoto Y, Pickford AR, Campbell ID, Werner JM. Biochemistry. 2000 Jul 25;39(29):8374-81. Interface characterization of the type II module pair from fibronectin.

- Verlet, L. (1967). Computer experiments on classical fluids. I. Thermodynamical properties of Lennard-Jones molecules. Phys. Rev. 159, 98-105.

- Wishart, D. S., Bigam, C. G., Yao, J., Abildgaard, F., Dyson, H. J., Oldfield, E., Markley, J. L., and Sykes, B. D.

(1995) J. Biomol. NMR 6, 135-140.

**Claims**

1.  A computational method of determining a three-dimensional conformation of a biomolecule from experimental nuclear Overhauser effect spectroscopy, NOESY, data having ambiguous NOE crosspeaks that can be attributed to two or more proton resonances, the method comprising:

    (a) creating in a computer a swarm of molecular structure generators, each having the same covalent structure as the biomolecule but with randomized initial conformation;
    (b) performing a restrained molecular dynamics simulation, thereby causing the molecular structure generators to explore possible conformations of the biomolecule subject to the restraints of a common NOE restraints list of interproton distances that describes the conformation of the biomolecule, the restraints list being derived from the experimental NOESY data and being common to all molecular structure generators;
    (c) for each molecular structure generator in the swarm:

    (i) back-calculating a hypothetical NOESY spectrum from the current conformation of the said molecular structure generator;
    (ii) normalizing the back-calculated NOESY spectrum against the experimental NOESY data by calculating correlation coefficients over the non-diagonal spectral intensities;
    (iii) for each of the crosspeaks of the back-calculated NOESY spectrum, calculating a goodness of fit between the back-calculated crosspeak and the corresponding crosspeak in the experimental NOESY data;
    (iv) updating the NOE restraints list with those interproton distances which resulted in an improved goodness of fit compared to a memorised record of the goodness of fit; and
    (v) degrading the memorised goodness of fit for the said molecular structure generator; and

    (d) repeating steps (b) and (c), whereby for the first repetition of steps (b) and (c), the comparison in step (c) (iv) is made with respect to a memorised record of the goodness of fit being set to infinity and, for further repetitions of steps (b) and (c), the comparison in step (c)(iv) is made with respect to the degraded memorised record of the goodness of fit of the previous repetition, the molecular structure generators thereby co-operating to find the optimal constraints and thus determine the said three-dimensional conformation.

2.  A method as claimed in claim 1 in which the randomized initial conformation comprises random atomic co-ordinates and torsional angles.

3.  A computer program which, when run on a computer, determines the three-dimensional conformation of a biomolecule using the method of claim 1.

4.  An apparatus adapted to determine a three-dimensional conformation of a biomolecule from experimental nuclear Overhauser effect spectroscopy, NOESY, data having ambiguous NOE crosspeaks that can be attributed to two or more proton resonances, the method comprising:

    (a) means for creating in a computer a swarm of molecular structure generators, each having the same covalent structure as the biomolecule but with randomized initial conformation;
    (b) means for performing a restrained molecular dynamics simulation, thereby causing the molecular structure generators to explore possible conformations of the biomolecule subject to the restraints of a common NOE restraints list of interproton distances that describes the conformation of the biomolecule, the restraints list being derived from the experimental NOESY data and being common to all molecular structure generators;
    (c) means for carrying out the following steps for each molecular structure generator in the swarm:

    (i) back-calculating a hypothetical NOESY spectrum from the current conformation of the said molecular structure generator;
    (ii) normalizing the back-calculated NOESY spectrum against the experimental NOESY data by calculating correlation coefficients over the non-diagonal spectral intensities;
    (vi) for each of the crosspeaks of the back-calculated NOESY spectrum, calculating a goodness of fit between the back-calculated crosspeak and the corresponding crosspeak in the experimental NOESY data;
    (vii) updating the NOE restraints list with those interproton distances which resulted in an improved goodness of fit compared to a memorised record of the goodness of fit; and

(viii) degrading the memorised goodness of fit for the said molecular structure generator; and

(d) repeating steps (b) and (c), whereby for the first repetition of steps (b) and (c), the comparison in step (c)(iv) is made with respect to a memorised record of the goodness of fit being set to infinity and, for further repetitions of steps (b) and (c), the comparison in step (c)(iv) is made with respect to the degraded memorised record of the goodness of fit of the previous repetition, the molecular structure generators thereby co-operating to find the optimal constraints and thus determine the said three-dimensional conformation.

**5.** An apparatus as claimed in claim 4 in which the randomized initial conformation comprises random atomic co-ordinates and torsional angles.

**Patentansprüche**

**1.** Berechnungsverfahren zur Bestimmung einer dreidimensionalen Konformation eines Biomoleküls aus experimentellen Daten der Kern-Overhauser-Effekt-Spektroskopie, NOESY, die mehrdeutige NOE-Kreuzsignale aufweisen, welche zwei oder mehr Protonenresonanzen zugeordnet werden können, wobei das Verfahren Folgendes umfasst:

(a) Erzeugen von einem Schwarm molekularer Strukturgeneratoren in einem Computer, von denen jeder dieselbe kovalente Struktur wie das Biomolekül aufweist, allerdings mit einer randomisierten Anfangskonformation;
(b) Durchführen einer eingeschränkten Molekulardynamik-Simulation, wodurch die molekularen Strukturgeneratoren veranlasst werden, mögliche Konformationen von dem Biomolekül zu erkunden, welche den Einschränkungen einer gemeinsamen NOE-Restraint-Liste von Interproton-Distanzen unterliegen, welche die Konformation von dem Biomolekül beschreibt, wobei die Restraint-Liste aus den experimentellen NOESY-Daten abgeleitet und allen molekularen Strukturgeneratoren gemeinsam ist;
(c) für jeden molekularen Strukturgenerator in dem Schwarm:

(i) Rückrechnen eines hypothetischen NOESY-Spektrums aus der gegenwärtigen Konformation von dem molekularen Strukturgenerator;
(ii) Normalisieren des rückgerechneten NOESY-Spektrums gegen die experimentellen NOESY-Daten durch Berechnung von Korrelationskoeffizienten über die nicht-diagonalen Spektralintensitäten;
(iii) Berechnung einer Anpassungsgüte zwischen dem rückgerechneten Kreuzsignal und dem entsprechenden Kreuzsignal in den experimentellen NOESY-Daten für jedes der Kreuzsignale von dem rückgerechneten NOESY-Spektrum;
(iv) Aktualisieren der NOE-Restraint-Liste mit denjenigen Interproton-Distanzen, welche im Vergleich zu einem gespeicherten Datensatz der Anpassungsgüte zu einer verbesserten Anpassungsgüte führten; und
(v) Herabsetzen der gespeicherten Anpassungsgüte für den molekularen Strukturgenerator; und

(d) Wiederholung der Schritte (b) und (c), wobei für die erste Wiederholung der Schritte (b) und (c) der Vergleich in Schritt (c)(iv) in Bezug auf einen gespeicherten Datensatz der Anpassungsgüte durchgeführt wird, die auf Unendlich gesetzt wird, und, für die weiteren Wiederholungen der Schritte (b) und (c), der Vergleich in Schritt (c)(iv) in Bezug auf den herabgesetzten gespeicherten Datensatz der Anpassungsgüte der vorhergehenden Wiederholung gemacht wird, wobei die molekularen Strukturgeneratoren kooperieren, um die optimalen Einschränkungen zu finden und auf diese Weise die dreidimensionale Konformation zu bestimmen.

**2.** Verfahren gemäß Anspruch 1, in dem die randomisierte Anfangskonformation zufällige Atomkoordinaten und Torsionswinkel aufweist.

**3.** Computerprogramm, welches, wenn es auf einem Computer läuft, die dreidimensionale Konformation eines Biomoleküls unter Verwendung des Verfahrens von Anspruch 1 bestimmt.

**4.** Apparatur, die eingerichtet ist zur Bestimmung einer dreidimensionalen Konformation eines Biomoleküls aus experimentellen Daten der Kern-Overhauser-Effekt-Spektroskopie, NOESY, die mehrdeutige NOE-Kreuzsignale aufweisen, welche zwei oder mehr Protonenresonanzen zugeordnet werden können, wobei das Verfahren Folgendes umfasst:

(a) Mittel zum Erzeugen von einem Schwarm molekularer Strukturgeneratoren in einem Computer, von denen jeder dieselbe kovalente Struktur wie das Biomolekül aufweist, allerdings mit einer randomisierten Anfangskonformation;

(b) Mittel zum Durchführen einer eingeschränkten Moleklardynamik-Simulation, wodurch die molekularen Strukturgeneratoren veranlasst werden, mögliche Konformationen von dem Biomolekül zu erkunden, welche den Einschränkungen einer gemeinsamen NOE-Restraint-Liste von Interproton-Distanzen unterliegen, welche die Konformation von dem Biomolekül beschreibt, wobei die Restraint-Liste aus den experimentellen NOESY-Daten abgeleitet und allen molekularen Strukturgeneratoren gemeinsam ist;

(c) Mittel zur Durchführung der folgenden Schritte für jeden molekularen Strukturgenerator in dem Schwarm:

    (i) Rückrechnen eines hypothetischen NOESY-Spektrums aus der gegenwärtigen Konformation von dem molekularen Strukturgenerator;

    (ii) Normalisieren des rückgerechneten NOESY-Spektrums gegen die experimentellen NOESY-Daten durch Berechnung von Korrelationskoeffizienten über die nicht-diagonalen Spektralintensitäten;

    (iii) Berechnung einer Anpassungsgüte zwischen dem rückgerechneten Kreuzsignal und dem entsprechenden Kreuzsignal in den experimentellen NOESY-Daten für jedes der Kreuzsignale von dem rückgerechneten NOESY-Spektrum;

    (iv) Aktualisieren der NOE-Restraint-Liste mit denjenigen Interproton-Distanzen, welche im Vergleich zu einem gespeicherten Datensatz der Anpassungsgüte zu einer verbesserten Anpassungsgüte führten; und

    (v) Herabsetzen der gespeicherten Anpassungsgüte für den molekularen Strukturgenerator; und

(d) Wiederholung der Schritte (b) und (c), wobei für die erste Wiederholung der Schritte (b) und (c) der Vergleich in Schritt (c)(iv) in Bezug auf einen gespeicherten Datensatz der Anpassungsgüte durchgeführt wird, die auf Unendlich gesetzt ist, und, für die weiteren Wiederholungen der Schritte (b) und (c), der Vergleich in Schritt (c) (iv) in Bezug auf den herabgesetzten gespeicherten Datensatz der Anpassungsgüte der vorhergehenden Wiederholung gemacht wird, wobei die molekularen Strukturgeneratoren kooperieren, um die optimalen Einschränkungen zu finden und auf diese Weise die dreidimensionale Konformation bestimmen.

5. Apparatur gemäß Anspruch 4, in der die randomisierte Anfangskonformation zufällige Atomkoordinaten und Torsionswinkel aufweist.

## Revendications

1. Procédé informatique de détermination d'une conformation tridimensionnelle d'une biomolécule à partir de données expérimentales de spectroscopie d'effet Overhauser nucléaire, NOESY, ayant des pics croisés d'effet Overhauser nucléaire NOE ambigus qui peuvent être attribués à deux résonances de proton ou plus, le procédé comprenant :

(a) la création dans un ordinateur d'un essaim de générateurs de structures moléculaires, ayant chacun la même structure covalente que la biomolécule, mais avec une conformation initiale rendue aléatoire ;

(b) l'exécution d'une simulation de dynamique moléculaire contrainte, ce qui fait en sorte que les générateurs de structures moléculaires explorent les conformations possibles de la biomolécule soumise aux contraintes d'une liste de contraintes NOE communes de distances inter-protons qui décrit la conformation de la biomolécule, la liste de contraintes étant dérivée des données NOESY expérimentales et étant commune à tous les générateurs de structures moléculaires ;

(c) pour chaque générateur de structures moléculaires dans l'essaim :

    (i) effectuer un rétro-calcul d'un spectre NOESY hypothétique à partir de la conformation actuelle dudit générateur de structures moléculaires ;

    (ii) normaliser le spectre NOESY rétrocalculé vis-à-vis des données NOESY expérimentales en calculant les coefficients de corrélation sur les intensités spectrales non diagonales ;

    (iii) pour chacun des pics croisés du spectre NOESY rétrocalculé, calculer une validité d'ajustement entre le pic croisé rétrocalculé et le pic croisé correspondant dans les données NOESY expérimentales ;

    (iv) mettre à jour la liste de contraintes NOE avec ces distances inter-protons qui ont donné une validité d'ajustement améliorée par comparaison avec un enregistrement mémorisé de la validité d'ajustement ; et

    (v) dégrader la validité d'ajustement mémorisée pour ledit générateur de structures moléculaires ; et

(d) la répétition des étapes (b) et (c), selon quoi pour la première répétition des étapes (b) et (c), la comparaison dans l'étape (c)(iv) est faite par rapport à un enregistrement mémorisé de la validité d'ajustement qui est défini sur l'infini et, pour les autres répétitions des étapes (b) et (c), la comparaison dans l'étape (c)(iv) est faite par rapport à l'enregistrement mémorisé dégradé de la validité d'ajustement de la répétition précédente, les générateurs de structures moléculaires coopérant de ce fait pour trouver les contraintes optimales et déterminer ainsi ladite conformation tridimensionnelle.

2. Procédé selon la revendication 1, dans lequel la conformation initiale rendue aléatoire comprend des coordonnées atomiques et angles de torsion aléatoires.

3. Programme informatique qui, lorsqu'il est exécuté sur un ordinateur, détermine la conformation tridimensionnelle d'une biomolécule en utilisant le procédé selon la revendication 1.

4. Appareil adapté pour déterminer une conformation tridimensionnelle d'une biomolécule à partir de données expérimentales de spectroscopie d'effet Overhauser nucléaire, NOESY, ayant des pics croisés d'effet Overhauser nucléaire NOE ambigus qui peuvent être attribués à deux résonances de proton ou plus, le procédé comprenant :

(a) un moyen pour créer dans un ordinateur d'un essaim de générateurs de structures moléculaires, ayant chacun la même structure covalente que la biomolécule, mais avec une conformation initiale rendue aléatoire ;
(b) un moyen pour exécuter une simulation de dynamique moléculaire contrainte, ce qui fait, en sorte que les générateurs de structures moléculaires explorent les conformations possibles de la biomolécule soumise aux contraintes d'une liste de contraintes NOE communes de distances inter-protons qui décrit la conformation de la biomolécule, la liste de contraintes étant dérivée des données NOESY expérimentales et étant commune à tous les générateurs de structures moléculaires ;
(c) un moyen pour effectuer les étapes suivantes pour chaque générateur de structures moléculaires dans l'essaim :

(i) effectuer un rétro-calcul d'un spectre NOESY hypothétique à partir de la conformation actuelle dudit générateur de structures moléculaires ;
(ii) normaliser le spectre NOESY rétrocalculé vis-à-vis des données NOESY expérimentales en calculant les coefficients de corrélation sur les intensités spectrales non diagonales ;
(vi) pour chacun des pics croisés du spectre NOESY rétrocalculé, calculer une validité d'ajustement entre le pic croisé rétrocalculé et le pic croisé correspondant dans les données NOESY expérimentales ;
(vii) mettre à jour la liste de contraintes NOE avec ces distances inter-protons qui ont donné une validité d'ajustement améliorée par comparaison avec un enregistrement mémorisé de la validité d'ajustement ; et
(viii) dégrader la validité d'ajustement mémorisée pour ledit générateur de structures moléculaires ; et

(d) la répétition des étapes (b) et (c), selon quoi pour la première répétition des étapes (b) et (c), la comparaison dans l'étape (c)(iv) est faite par rapport à un enregistrement mémorisé de la validité d'ajustement qui est défini sur l'infini et, pour les autres répétitions des étapes (b) et (c), la comparaison dans l'étape (c)(iv) est faite par rapport à l'enregistrement mémorisé dégradé de la validité d'ajustement de la répétition précédente, les générateurs de structures moléculaires coopérant de ce fait pour trouver les contraintes optimales et déterminer ainsi ladite conformation tridimensionnelle.

5. Appareil selon la revendication 4, dans lequel la conformation initiale rendue aléatoire comprend des coordonnées atomiques et angles de torsion aléatoires.

FIG. 1

Overview of the Architecture of NMRSwarm

FIG. 2

Preparation of the Topology and Swarm

FIG. 3

Preparation of the NMR Data

FIG. 4

On-the-Fly NOESY Backcalculation in NMRSwarm

# FIG. 6

The Graphical User Interfaces (GUIs) of NMRSwarm

NMRSwarm: Geometry Main Window - [/home/tddy/NMRSwarm/model.sq.xml]

File  Edit  View  Tools  Window  Options  Help

| Atoms | Bonds | Bond Angles | Dihedral Angles | Improper Angles | Notes |

| Chemical | Chemical | Chemical | Chemical | Equilibrium | Periodicity | Force | |
|----------|----------|----------|----------|-------------|-------------|-------|---|
| C | CH2E | CH2E | CH1E | 0.000 | 3 | 5.0 | |
| C | N | CH1E | C | 0.000 | 3 | 2.0 | |
| C | NH1 | CH1E | C | 0.000 | 3 | 2.0 | |
| C | NH1 | CH2G | C | 0.000 | 3 | 2.0 | |
| C | NH1 | CH3E | C | 0.000 | 3 | 2.0 | |
| CH1E | C | N | CH1E | 180.000 | 2 | 10.0 | |
| CH1E | CH1E | CH2E | CH3E | 0.000 | 3 | 5.0 | |
| CH1E | CH2E | CH2E | CH2E | 0.000 | 3 | 5.0 | |
| CH1E | CH2E | CH2E | SM | 0.000 | 3 | 5.0 | |
| CH1E | CH2E | CY | CR1E | 90.000 | 2 | 5.0 | |
| CH2E | CH1E | CH1E | NH1 | 0.000 | 3 | 5.0 | |
| CH2E | CH2E | CH2E | CH2E | 0.000 | 3 | 5.0 | |
| CH2E | CH2E | CH2E | NH1 | 0.000 | 3 | 5.0 | |
| CH2E | CH2E | NH1 | C | 0.000 | 3 | 5.0 | |
| CH3E | CH2E | SM | CH3E | 0.000 | 3 | 5.0 | |

Chemical 1: C  Chemical 2: N  Chemical 3: CH1E  Chemical 4: C

Equilibrium  0.000

Periodicity  3

Force constant  2.0

Help

FIG.  7

The Geometry GUI of NMRSwarm

FIG. 8

The Library GUI of NMRSwarm

FIG. 9

Building a Segment in the Topology GUI of NMRSwarm

# FIG. 10

The Segment Viewer in the Topology GUI of NMRSwarm

FIG. 11

The NOE Viewer/Editor in the Topology GUI of NMRSwarm

FIG. 12

The Swarm GUI of NMRSwarm

# FIG. 13

The NMR Conditions GUI of NMRSwarm

FIG. 14

The NMR Spectrum GUI of NMRSwarm

FIG. 15

FIG.    16

```
┌─────────────────────────┐
│    Experimental Data     │
│    . NOESY Spectra       │
│    .Chemical Shifts      │
└─────────────────────────┘
             │
             ▼
      ┌──────────────┐
 ┌───▶│   Pick NOE   │
 │    │    peaks     │
 │    └──────────────┘
 │            │
 │            ▼
 │     ┌──────────────┐
 │ ┌──▶│     NOE      │───┐
 │ │   │  assignment  │   │
 │ │   └──────────────┘   │
 │ │                      ▼
┌──────────┐         ┌──────────┐
│Structure │         │   NOE    │
│selection │         │calibration│
└──────────┘         └──────────┘
 │   ▲                      │
 │   │   ┌──────────────┐   │
 │   └───│  Structure   │◀──┘
 │       │ calculation  │
 │       └──────────────┘
 ▼
┌──────────┐
│  Final   │
│structures│
└──────────┘
```

FIG.    17

Experimental Data
. NOESY Spectra
.Chemical Shifts
.Resonance Linewidths

Molecular
dynamics

Molecular
dynamics

Molecular
dynamics

NOE
restraints

Molecular
dynamics

Molecular
dynamics

Molecular
dynamics

Molecular
dynamics

— — — ▶ : NOE restraints

◀ · · · · · · · · : NOESY back-calculation

# FIG.    18

FIG.    19

EP 1 929 322 B1

FIG. 20

FIG. 21

FIG. 22

FIG. 23

FIG. 24

NMR Swarm
Structure Ensemble

NMR Swarm
Average Structure

Structure

FIG. 25

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **MEILER J ; WILL M.** Automated structure elucidation of organic molecules from 13C NMR spectra using genetic algorithm and neural networks. *J Chem Inf Comput Sci,* 2001, vol. 41, 1535-1546
- **BERENDSEN, H.J.C. ; POSTMA, J.P.M. ; VAN GUNSTEREN, N.F. ; DINOLA, A. ; HAAK, J.R.** Molecular dynamics with coupling to an external bath. *J. Chem Phys.,* 1984, vol. 81, 3684-3690
- **BRIGHT JR ; PICKFORD AR ; POTTS JR ; CAMPBELL ID.** *Methods Mol Biol.,* 2000, vol. 139, 59-69
- **F. DELAGLIO ; S. GRZESIEK ; G. W. VUISTER ; G. ZHU ; J. PFEIFER ; A. BAX.** NMRPipe: A multidimensional spectral processing system based on UNIX pipes. *J. Biomol. NMR.,* 1995, vol. 6, 277-293
- **DE PEREDA JM ; WEGENER KL ; SANTELLI E ; BATE N ; GINSBERG MH ; CRITCHLEY DR ; CAMPBELL ID ; LIDDINGTON RC.** *J Biol Chem.,* 04 March 2005, vol. 280 (9), 8381-6
- **PICKFORD AR ; POTTS JR ; BRIGHT JR ; PHAN I ; CAMPBELL ID.** *Structure,* 15 March 1997, vol. 5 (3), 359-70
- **SMITH SP ; HASHIMOTO Y ; PICKFORD AR ; CAMPBELL ID ; WERNER JM.** *Biochemistry,* 25 July 2000, vol. 39 (29), 8374-81
- **VERLET, L.** Computer experiments on classical fluids. I. Thermodynamical properties of Lennard-Jones molecules. *Phys. Rev.,* 1967, vol. 159, 98-105
- **WISHART, D. S. ; BIGAM, C. G. ; YAO, J. ; ABILDGAARD, F. ; DYSON, H. J. ; OLDFIELD, E. ; MARKLEY, J. L. ; SYKES, B. D.** *J. Biomol. NMR,* 1995, vol. 6, 135-140